(19) Europäisches Patentamt
European Patent Office
Office européen des brevets

(11) **EP 3 298 343 B1**

(12) **EUROPÄISCHE PATENTSCHRIFT**

(45) Veröffentlichungstag und Bekanntmachung des Hinweises auf die Patenterteilung:
**27.11.2019 Patentblatt 2019/48**

(21) Anmeldenummer: **16729770.4**

(22) Anmeldetag: **18.05.2016**

(51) Int Cl.:
*G01B 9/02* (2006.01)  *G03F 7/20* (2006.01)
*G02B 5/08* (2006.01)  *G01M 11/00* (2006.01)
*G01B 11/24* (2006.01)

(86) Internationale Anmeldenummer:
**PCT/EP2016/000820**

(87) Internationale Veröffentlichungsnummer:
**WO 2016/188620 (01.12.2016 Gazette 2016/48)**

(54) **INTERFEROMETRISCHE MESSANORDNUNG**

INTERFEROMETRIC MEASURING ARRANGEMENT

DISPOSITIF DE MESURE INTERFÉROMÉTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.05.2015 DE 102015209490**

(43) Veröffentlichungstag der Anmeldung:
**28.03.2018 Patentblatt 2018/13**

(73) Patentinhaber: **Carl Zeiss SMT GmbH**
**73447 Oberkochen (DE)**

(72) Erfinder:
- **HETZLER, Jochen**
  **73434 Aalen (DE)**
- **FUCHS, Sebastian**
  **73433 Aalen (DE)**
- **STIEPAN, Hans-Michael**
  **73430 Aalen (DE)**
- **SCHUSTER, Karl-Heinz**
  **89551 Königsbronn (DE)**

(74) Vertreter: **Zeuner Summerer Stütz**
**Nußbaumstrasse 8**
**80336 München (DE)**

(56) Entgegenhaltungen:
**DE-A1- 19 643 074     DE-A1-102012 217 800**

- **MASARU KINO AND MIKIO KURITA: "Interferometric testing for off-axis aspherical mirrors with computer-generated holograms", APPLIED OPTICS, OPTICAL SOCIETY OF AMERICA, WASHINGTON, DC; US, Bd. 51, Nr. 19, 1. Juli 2012 (2012-07-01), Seiten 4291-4297, XP001576955, ISSN: 0003-6935, DOI: 10.1364/AO.51.004291 [gefunden am 2012-06-22]**

**Beschreibung**

Hintergrund der Erfindung

Die Erfindung betrifft eine Messanordnung und ein Verfahren zum interferometrischen Bestimmen einer Form einer Oberfläche eines Testobjekts.

Zur hochgenauen interferometrischen Vermessung einer Oberflächenform eines Testobjekts, etwa eines optischen Elements für die Mikrolithographie, werden häufig diffraktive optische Anordnungen als so genannte Nulloptiken verwendet. Dabei wird die Wellenfront einer Prüfwelle durch ein diffraktives Element derart an eine Sollform der Oberfläche angepasst, dass diese an jedem Ort senkrecht auf die Sollform auftreffen und von dieser in sich zurück reflektiert würde. Abweichungen von der Sollform lassen sich durch Überlagerung der reflektierten Prüfwelle mit einer Referenzwelle bestimmen. Als diffraktives Element kann beispielsweise ein computergeneriertes Hologramm (CGH) eingesetzt werden.

In DE 10 2012 217 800 A1 wird eine solche Messanordnung mit einem komplex kodierten CGH beschrieben. Eine Lichtwelle wird zunächst durch ein Fizeau-Element in eine Referenzwelle und eine Prüfwelle geteilt. Die Prüfwelle wird anschließend von dem komplex kodierten CGH in eine Prüfwelle mit einer an die Sollform der Oberfläche angepassten Wellenfront und Kalibrierwellen mit sphärischer oder ebener Wellenfront umgewandelt. Hierfür enthält das CGH geeignet ausgebildete diffraktive Strukturen. Die Kalibrierwellen werden zur Kalibrierung des CGHs verwendet. Anschließend wird ein Testobjekt in der Prüfposition angeordnet und eine Messung mit der Prüfwelle durchgeführt. Die Prüfwelle wird von der Oberfläche des Testobjekts reflektiert, von dem CGH rücktransformiert und nach Durchlaufen des Fizeau-Elements von der Referenzwelle überlagert. Aus dem in einer Ebene erfassten Interferogramm lässt sich die Form der Oberfläche bestimmen. Dabei wird durch die Kalibrierung des CGHs eine sehr hohe Genauigkeit erzielt.

Ein Problem bei der Vermessung von hochgenauen Oberflächen mit den bekannten interferometrischen Vorrichtungen besteht jedoch darin, dass zwischen der Kalibrierung und der anschließenden Messung des Testobjekts eine Änderung der optischen Eigenschaften des CGHs oder anderer optischer Elemente des Interferometers auftreten können. Solche Änderungen werden insbesondere durch Temperaturänderungen verursacht. Bei einem CGH mit Quarzsubstrat können nach einer Kalibrierung bereits inhomogene Temperaturänderungen im mK-Bereich eine Reduzierung der Messgenauigkeit bewirken.

Dieses Problem tritt insbesondere bei großen und schweren Testobjekten auf, wie beispielsweise EUV-Spiegel für die Mikrolithographie. Diese Testobjekte lassen sich nur langsam in eine Prüfposition bewegen. Dabei kommt es zu einem deutlichen Energie- und somit auch Wärmeeintrag in die Messanordnung. Auch Oberflächen von optischen Elementen mit einer gegenüber der Umgebung deutlich höheren Temperatur können nur mit einer unzureichenden Messgenauigkeit bestimmt werden. Solche optischen Elemente könnten durch angestrebte Leistungssteigerungen der Belichtungsstrahlung und einer damit einhergehenden stärkeren Erwärmung der optischen Elemente in der EUV-Mikrolithographie zum Einsatz kommen.

Zugrunde liegende Aufgabe

Es ist eine Aufgabe der Erfindung, eine Vorrichtung sowie ein Verfahren bereitzustellen, womit die vorgenannten Probleme gelöst werden, und insbesondere eine hochgenaue Bestimmung der Oberflächenform von großen oder gegenüber der Umgebung wärmeren Testobjekten ermöglicht wird.

Erfindungsgemäße Lösung

Die Aufgabe wird erfindungsgemäß durch die nachstehende Messanordnung, wie im unabhängigen Anspruch 1 definiert, zur interferometrischen Bestimmung einer Form einer Oberfläche eines Testobjekts gelöst. Die Messanordnung umfasst eine Lichtquelle zum Bereitstellen einer Eingangswelle und ein diffraktives optisches Element, welches im Strahlengang der Eingangswelle angeordnet und geeignet konfiguriert ist, jeweils durch Beugung in betragsmäßig erster oder höherer Ordnung aus der Eingangswelle einerseits eine auf das Testobjekt gerichtete Prüfwelle mit einer zumindest teilweise an eine Sollform der optischen Oberfläche angepassten Wellenfront und andererseits eine Referenzwelle mit einer von einer Ausbreitungsrichtung der Prüfwelle abweichenden Ausbreitungsrichtung zu erzeugen. Weiterhin weist das diffraktive optische Element in einer Ebene zwei sich überlagernd angeordnete diffraktive Strukturmuster auf, wobei eines der diffraktiven Strukturmuster zur Erzeugung der Prüfwelle und das andere diffraktive Strukturmuster zur Erzeugung der Referenzwelle ausgebildet ist. Weiterhin umfasst die Messvorrichtung ein reflektives optisches Element, welches im Strahlengang der Referenzwelle angeordnet ist und zur Rückreflexion der Referenzwelle ausgebildet ist, und eine Erfassungseinrichtung zum Erfassen eines Interferogramms, welches durch eine Überlagerung der Prüfwelle nach Wechselwirkung mit dem Testobjekt und der rückreflektierten Referenzwelle, jeweils nach erneuter Beugung am diffraktiven Element, in einer Erfassungsebene erzeugt wird.

Weiterhin wird die Aufgabe durch das nachfolgend im Anspruch 10 definierte Verfahren zum interferometrischen Bestimmen einer Form einer Oberfläche eines Testobjekts gelöst. Das Verfahren umfasst die Schritte: Bereitstellen einer Eingangswelle, Erzeugen einer auf das Testobjekt gerichteten Prüfwelle mit einer zumindest teilweise an eine Sollform der optischen Oberfläche angepassten Wellenfront und einer auf ein reflektives optisches Element gerichteten Referenzwelle mit einer von einer Ausbreitungsrichtung der Prüfwelle abweichenden Ausbreitungsrichtung aus der Eingangswelle jeweils durch Beugung in betragsmäßig erster oder höherer Ordnung an einem diffraktiven optischen

Element, Überlagern der Prüfwelle nach Wechselwirkung mit dem Testobjekt mit der Referenzwelle nach Rückreflexion am reflektiven optischen Element, wobei die Prüfwelle und die Referenzwelle zur Überlagerung jeweils am diffraktiven optischen Element erneut gebeugt werden, und Erfassen eines durch die Überlagerung der Prüfwelle und der Referenzwelle in einer Erfassungsebene erzeugten Interferogramms, wobei das diffraktive optische Element in einer Ebene zwei sich überlagernd angeordnete diffraktive Strukturmuster aufweist, wobei eines der diffraktiven Strukturmuster zur Erzeugung der Prüfwelle und das andere diffraktive Strukturmuster zur Erzeugung der Referenzwelle ausgebildet ist.

Unter dem Begriff "Beugung" ist im Rahmen dieses Textes eine Beugung in erster oder höherer Ordnung zu verstehen. Eine nullte Beugungsordnung einer auf ein diffraktives Element eingestrahlten Welle wird in diesem Text nicht als eine "durch Beugung" erzeugte Welle angesehen. Das in der vorstehenden erfindungsgemäßen Messanordnung bzw. im vorstehenden erfindungsgemäßen Verfahren enthaltene diffraktive optische Element ist damit dazu konfiguriert, aus der Eingangswelle einerseits die Prüfwelle durch Beugung in betragsmäßig erster oder höherer Ordnung und andererseits die Referenzwelle durch Beugung in betragsmäßig erster oder höherer Ordnung zu erzeugen.

Mit anderen Worten stellt die erfindungsgemäße Messanordnung ein Interferometer dar, bei dem ein diffraktives optisches Element einerseits als Strahlenteiler zur Erzeugung einer Prüfwelle und einer Referenzwelle eingesetzt wird. Andererseits wird das diffraktive Element gleichzeitig als Nulloptik zum Anpassen der Wellenfront der Prüfwelle an eine Sollform der Oberfläche des Testobjekts verwendet. Ein separater Strahlenteiler, wie etwa ein Fizeau-Element, zum Teilen der Eingangswelle in eine Prüfwelle und eine Referenzwelle wird nicht benötigt. Nach einer Wechselwirkung mit dem Testobjekt bzw. dem reflektiven optischen Element dient dasselbe diffraktive optische Element zur Überlagerung der Prüfwelle mit der Referenzwelle. Somit wirken Abweichungen des diffraktiven Elements von einer Sollform, beispielsweise durch eine Erwärmung während des Betriebs, sowohl auf die Prüfwelle als auch auf die Referenzwelle ein. Bei der Überlagerung der Prüfwelle mit der Referenzwelle werden diese Fehler weitestgehend kompensiert. Entsprechend wird bei dem erfindungsgemäßen Verfahren vorgegangen. Die erfindungsgemäße Messanordnung und das korrespondierende Verfahren eignen sich somit insbesondere zur Vermessung von großen asphärischen Oberflächen von gegenüber der Umgebung wärmeren Testobjekten.

Die Wechselwirkung der Prüfwelle mit dem Testobjekt kann eine Reflexion, z.B. für den Fall, in dem das Testobjekt als Spiegel ausgeführt ist, oder eine Transmission, z.B. im Fall, in dem das Testobjekt als Linse ausgeführt ist, sein. Im letzteren Fall wird vorzugsweise die Prüfwelle nach Durchtritt durch die Linse an einem Spiegel zurückreflektiert.

Gemäß einer Ausführungsform ist das diffraktive optische Element dazu konfiguriert die Prüfwelle und die Referenzwelle in Transmission durch Beugung zu erzeugen. Alternativ können beide Wellen durch das diffraktive optische Element auch in Reflexion durch Beugung erzeugt werden. Vorzugsweise ist im Strahlengang der Prüfwelle nach der Erzeugung am diffraktiven optischen Element als nächstes optisches Element das Testobjekt angeordnet. Entsprechend kann im Strahlengang der Referenzwelle nach dem diffraktiven optischen Element als nächstes optisches Element das reflektive optische Element angeordnet sein. Durch diese Maßnahme werden zwei Interferometerarme aufgespannt, in denen sich kein weiteres optisches Material befindet, welches beispielsweise durch Erwärmung Messfehler induzieren könnte.

Gemäß einer weiteren Ausführungsform wird bei der erneuten Beugung die Prüfwelle mit der gleichen Beugungsordnung am diffraktiven optischen Element gebeugt wie die Eingangswelle bei der zur Erzeugung der Prüfwelle erfolgten Beugung am diffraktiven optischen Element. Wird als z.B. die Prüfwelle durch Beugung der Eingangswelle am diffraktiven optischen Element in erster Beugungsordnung erzeugt, so erfolgt auch die nach der Wechselwirkung mit dem Testobjekt erfolgende erneute Beugung der Prüfwelle am diffraktiven optischen Element in erster Beugungsordnung.

Gemäß einer weiteren Ausführungsform wird bei der erneuten Beugung die Referenzwelle mit der gleichen Beugungsordnung am diffraktiven optischen Element gebeugt wie die Eingangswelle bei der zur Erzeugung der Referenzwelle erfolgten Beugung am diffraktiven optischen Element.

Gemäß einer weiteren Ausführungsform ist die Ausbreitungsrichtung der durch Beugung am diffraktiven optischen Element aus der Eingangswelle erzeugten Referenzwelle gegenüber der Ausbreitungsrichtung der Eingangswelle um mehr als 1°, insbesondere um mehr als 5°, verkippt.

Gemäß einer weiteren Ausführungsform wird bei der erneuten Beugung am diffraktiven optischen Element eine durch Überlagerung der Prüfwelle nach Wechselwirkung mit dem Testobjekt und der rückreflektierten Referenzwelle gebildete Rücklaufwelle erzeugt, wobei die Ausbreitungsrichtung der Rücklaufwelle gegenüber der umgekehrten Ausbreitungsrichtung der Eingangswelle um weniger als 1° verkippt ist.

Gemäß einer weiteren Ausführungsform weicht die Wellenfront der Prüfwelle nach der erneuten Beugung am diffraktiven optischen Element um maximal 10 $\mu$m, insbesondere um maximal 1 $\mu$m, von einer an die Wellenfront der Eingangswelle bestangepassten sphärischen Wellenfront ab. Zu Bestimmung der bestangepassten sphärischen Wellenfront kann beispielsweise die mittlere quadratische Abweichung (rms) als Kriterium minimiert werden. Unter einer Abweichung von maximal 10 $\mu$m von der bestangepassten sphärischen Wellenfront ist zu verstehen, dass die am Ort der größten Abweichung der Wellenfront der Prüfwelle nach der erneuten Beugung von der Wellenfront der bestangepassten sphärischen Welle vorliegende Abweichung höchstens 10 $\mu$m beträgt.

Gemäß der Erfindung weist das diffraktive optische Element in einer Ebene zwei sich überlagernd angeordnete diffraktive Strukturmuster auf, wobei eines der diffraktiven Strukturmuster zur Erzeugung der Prüfwelle und das andere diffraktive Strukturmuster zur Erzeugung der Referenzwelle ausgebildet ist. Das diffraktive optische Element kann hierfür beispielsweise ein komplex kodiertes CGH umfassen. Das komplex kodierte CGH weist in einer Ebene diffraktive Strukturen auf, welche sich aus einer Überlagerung des diffraktiven Strukturmusters für die Prüfwelle und des diffraktiven Strukturmusters für die Referenzwelle ergeben. Vorzugsweise erzeugt das komplex kodierte CGH beide Wellen in Transmission oder beide Wellen in Reflexion. Dadurch lassen sich die diffraktiven Strukturen des CGH in einem Herstellungsprozess anfertigen und unterliegen somit den gleichen Herstellungstoleranzen bzw. Herstellungsfehlern. Diese lassen sich bei einer Kalibrierung des CGHs ermitteln. Insbesondere werden betriebsbedingte, z.B. durch Erwärmung verursachte Abweichungen der diffraktiven Strukturen von einer Sollform bei der Überlagerung der Prüfwelle mit der Referenzwelle kompensiert. Die Eingangswelle der erfindungsgemäßen Messanordnung weist entweder eine ebene, eine sphärische oder eine Freiformwellenfront auf. Als Freiformwellenfront wird hier eine Wellenfront einer elektromagnetischen Welle bezeichnet, welche von jeder beliebigen idealen Sphäre, insbesondere von der an die Wellenfront bestangepassten Sphäre, eine Abweichung von mindestens 10 $\lambda$ aufweist, wobei $\lambda$ die Wellenlänge der Welle ist. Mit anderen Worten weicht die Wellenfront der Freiformwellenfront bei mindestens einem Punkt um mindestens 10 $\lambda$ von jeder idealen Sphäre ab.

Nach einer erfindungsgemäßen Ausführungsform ist ein Kollimator im Strahlengang der Eingangswelle zum Erzeugen einer kollimierten Eingangswelle mit ebener Wellenfront aus der Eingangswelle vorgesehen. Andere Ausführungsformen weisen eine geeignet ausgebildete optische Anordnung zum Erzeugen einer Eingangswelle mit einer sphärischen Wellenfront oder mit einer Freiformwellenfront in dem Strahlengang der Eingangswelle auf. Je nach Oberfläche des Testobjekts und des verwendeten diffraktiven Elements eignet sich einer der oben genannten Wellenfrontformen bevorzugt für eine Oberflächenmessung.

Gemäß einer Ausführungsform nach der Erfindung umfasst das reflektive optische Element einen ebenen Spiegel zur Rückreflektion einer Referenzwelle mit ebener Wellenfront. In alternativen erfindungsgemäßen Ausführungsformen kann das reflektive optische Element einen konkaven oder konvexen sphärischen Spiegel zur Rückreflexion einer Referenzwelle mit sphärischer Wellenfront oder einen Spiegel mit einer Freiformfläche als Reflexionsfläche zur Rückreflexion einer Referenzwelle mit Freiformwellenfront aufweisen. Unter einer Freiformfläche wird hier eine nicht-rotationssymmetrische, nicht-sphärische Fläche verstanden, welche z.B. mittels Polynomen oder Splines beschreibbar ist.

Bei einer Ausführungsform nach der Erfindung ist die diffraktive Strukturmuster zur Erzeugung der Referenzwelle weiterhin zum derartigen Anpassen der Wellenfront der Referenzwelle an die Form des reflektiven optischen Elements ausgebildet, dass die Referenzwelle zum diffraktiven Element zurück reflektiert wird. Insbesondere ist das diffraktive Strukturmuster derart konfiguriert, dass die Referenzwelle in sich zurück reflektiert wird. Hierdurch muss die Eingangswelle nicht mehr eine an das reflektive optische Element angepasste Wellenfront aufweisen. Eine Anpassung der Wellenfront der Referenzwelle findet nun durch das diffraktive optische Element statt.

Gemäß einer Ausführungsform nach der Erfindung ist das reflektive optische Element gegenüber einer zur Ausbreitungsrichtung der Referenzwelle senkrecht angeordneten Achse kippbar gelagert. Durch entsprechende Verkippung des reflektiven optischen Elements erfolgt eine Verkippung der Referenzwelle gegenüber der Prüfwelle. Auf diese Weise lässt sich eine dem Fachmann bekannte und beispielsweise in US 5,361,312 beschriebene Vielstreifeninterferometrie bzw. Displaced-Measurement-Interferometrie (DMI) realisieren.

Bei einer weiteren Ausführungsform nach der Erfindung ist das reflektive optische Elemententlang einer Ausbreitungsrichtung der Referenzwelle verschiebbar gelagert. Insbesondere ist der das reflektive optische Element schrittweise in Bruchteilen der Wellenlänge der Referenzwelle oder kontinuierlich verschiebbar. Hiermit lässt sich eine dem Fachmann beispielsweise aus US 5,361,312 bekannte Phasenverschiebeinterferometrie realisieren. Insbesondere ist das verschiebbar gelagerte reflektive optische Element als Planspiegel konfiguriert.

Gemäß weiterer erfindungsgemäßer Ausführungsformen weist das reflektive optische Element, das diffraktive optische Element oder beide optische Elemente ein jeweiliges Substrat auf, welches ein optisches Material mit einem Wärmeausdehnungskoeffizient im Temperaturbereich 5°C bis 35°C von betragsmäßig höchstens $0,5 \times 10^{-6} \mathrm{K}^{-1}$ enthält (d.h. der Wärmeausdehnungskoeffizient beträgt mindestens $-0,5 \times 10^{-6} \mathrm{K}^{-1}$ und höchstens $+0,5 \times 10^{-6} \mathrm{K}^{-1}$. Insbesondere beträgt der Wärmeausdehnungskoeffizient im Temperaturbereich 0°C bis 50°C betragsmäßig höchstens $0,05 \times 10^{-6} \mathrm{K}^{-1}$. Beispiele für optische Materialien mit sehr kleinem Wärmeausdehnungskoeffizient umfassen Quarz, Zerodur®, ein Produkt der Schott AG und ULE®-Glas (Ultra Low Expansion Glas), ein Produkt der Corning Inc. Alternativ oder zusätzlich enthält das Substrat ein athermales optisches Material. Als athermales optisches Material wird ein Material bezeichnet, bei dem sich temperaturbedingte Änderungen des Brechungsindex und eine Ausdehnung des Materials in ihrer optischen Wirkung zumindest teilweise kompensieren. Somit ist die optische Weglänge in diesen Materialien weitgehend unabhängig von der Temperatur. Beispiele für athermale optische Materialien umfassen Calciumfluorid ($CaF_2$) und das P-PK53, ein Produkt der Schott AG. Weiterhin kann das Substrat auch aus Schichten unterschiedlicher Materialien aufgebaut sein. Temperaturabhängige Änderungen der optischen Eigenschaften des diffraktiven bzw. reflektiven optischen Elements werden durch diese Maßnahmen wirksam reduziert.

Gemäß einer Ausführungsform nach der Erfindung ist die Messanordnung innerhalb einer mit Luft unter einem Druck von kleiner als 100 mbar oder mit Helium unter Atmosphärendruck gefüllten Kammer angeordnet. Ein solches Vakuum oder Helium weisen nur eine geringe temperaturabhängige Änderung des Brechungsindex auf. Vakuum hat ferner den Vorteil, dass keine nennenswerte Wärmeleitung oder Konvektion auftritt.

Bei weiteren erfindungsgemäßen Ausführungsformen enthält die Messanordnung weiterhin mindestens einen Hitzeschild zur Abschirmung des diffraktiven optischen Elements, des reflektiven optischen Elements oder beider optischer Elemente gegenüber Wärmestrahlung von Wärmequellen. Die Anordnung eines Hitzeschildes kann beispielsweise in unmittelbarer Nähe bei dem diffraktiven optischen Element, dem reflektiven optischen Element oder bei einer Wärmequelle erfolgen. Ein Hitzeschild enthält nach einer Ausführungsform auf einer Oberfläche eine Beschichtung aus einem Wärmestrahlung absorbierenden Material. Auf einer gegenüberliegenden Oberfläche kann eine Beschichtung aus einem Wärmestrahlung stark reflektierenden Material, wie etwa Gold, vorgesehen sein. Vorzugsweise ist die absorbierende Beschichtung auf der zum diffraktiven oder reflektiven optischen Element zeigenden Oberfläche des Hitzeschilds angeordnet. Auf diese Weise werden eine Erwärmung des diffraktiven bzw. des reflektiven optischen Elements und damit einhergehende Messfehler effektiv minimiert.

Gemäß einer Ausführungsform nach der Erfindung enthält die Messanordnung eine Heizvorrichtung zum Beheizen des Testobjekts auf eine vorgegebene Temperatur. Insbesondere ist die Heizvorrichtung zum Beheizen des Testobjekts auf eine Temperatur von größer als 32°C oder größer als 35°C oder größer als 40°C geeignet konfiguriert. Vorzugsweise regelt die Heizvorrichtung das gesamte Testobjekt mindestens während der Dauer einer Messung auf eine vorgegebene Temperatur und berücksichtig dabei auch durch Messstrahlung oder durch Wärmestrahlung oder Wärmeleitung von anderen Komponenten der Messanordnung induzierte Wärme. Hierdurch lässt sich eine Oberfläche von Testobjekten, z.B. EUV-Spiegel, bei ihrer vorgesehenen, deutlich über der Umgebungstemperatur liegenden Betriebstemperatur vermessen.

Gemäß einer erfindungsgemäßen Ausführungsform der Messanordnung ist zusätzlich ein planer Kalibrierspiegel vorgesehen und das diffraktive optische Element dazu konfiguriert, durch Beugung aus der Eingangswelle weiterhin eine auf den Kalibrierspiegel gerichtete Kalibrierwelle mit einer ebenen Wellenfront zu erzeugen. Insbesondere umfasst das diffraktive optische Element in einer Ausführungsform mindestens eine diffraktive Struktur zum Erzeugen der Prüfwelle und der Referenzwelle sowie eine weitere diffraktive Struktur zum Erzeugen der Kalibrierwelle mit einer ebenen Wellenfront aus der Eingangswelle. Vorzugsweise sind in einer Ebene drei sich überlagernde diffraktive Strukturen in dem diffraktiven optischen Element zur Erzeugung der Prüfwelle, der Referenzwelle und der ebenen Kalibrierwelle vorgesehen. Hierfür kann beispielsweise ein entsprechend ausgebildetes komplex kodiertes CGH verwendet werden. Gemäß einer Ausführungsform wird die Kalibrierwelle von dem planen Kalibrierspiegel in sich zurückreflektiert. Auf diese Weise kann die Kalibrierwelle nach erneuter Beugung durch das diffraktive Element durch eine Überlagerung mit der Referenzwelle von der Erfassungseinrichtung vermessen werden. Hierdurch wird eine sehr genaue Kalibrierung des diffraktiven Elements, der Erfassungseinheit und weiterer Komponenten der Messanordnung ermöglicht.

Entsprechend ist in einer weiteren erfindungsgemäßen Ausführungsform zusätzlich ein sphärischer Kalibrierspiegel vorgesehen und das diffraktive optische Element dazu konfiguriert, durch Beugung aus der Eingangswelle eine auf den sphärischen Kalibrierspiegel gerichtete Kalibrierwelle mit einer sphärischen Wellenfront zu erzeugen. Insbesondere umfasst das diffraktive optische Element eine weitere diffraktive Struktur zum Erzeugen der Kalibrierwelle mit einer sphärischen Wellenfront aus der Eingangswelle. Auch hier können drei sich überlagernde diffraktive Strukturmuster in einer Ebene, z.B. als komplex kodiertes CGH, in dem diffraktiven optischen Element zur Erzeugung der Prüfwelle, der Referenzwelle und der sphärischen Kalibrierwelle vorgesehen sein. Vorzugsweise wird die sphärische Kalibrierwelle von dem sphärischen Kalibrierspiegel in sich zurückreflektiert und nach erneuter Beugung am diffraktiven optischen Element und Überlagerung mit der Referenzwelle von der Erfassungseinrichtung vermessen. Auch auf diese Weise wird eine sehr genaue Kalibrierung des diffraktiven optischen Elements erzielt.

Gemäß einer Ausführungsform der Erfindung sind zusätzlich ein planer Kalibierspiegel und ein sphärischer Kalibrierspiegel vorgesehen und das diffraktive optische Element ist dazu konfiguriert, durch Beugung aus der Eingangswelle weiterhin eine auf den planen Kalibrierspiegel gerichtete Kalibrierwelle mit einer ebenen Wellenfront sowie eine auf den sphärischen Kalibrierspiegel gerichtete Kalibrierwelle mit einer sphärischen Wellenfront zu erzeugen. Insbesondere umfasst das diffraktive optische Element diffraktive Strukturen zur Erzeugung der Prüfwelle, der Referenzwelle, einer ebenen Kalibrierwelle und einer sphärischen Kalibrierwelle. Vorzugsweise umfasst das diffraktive optische Element eine diffraktive Struktur, welche eine Überlagerung von vier diffraktiven Strukturmustern zur Erzeugung jeweils einer der oben genannten Wellen darstellt. Hierfür kann beispielsweise ein komplex kodiertes CGH verwendet werden, wie es in der DE 10 2012 217 800 A1 offenbart wird. Mit zwei Kalibrierwellen wird eine hochgenaue Kalibrierung des diffraktiven optischen Elements möglich.

Zusätzlich umfasst die Messanordnung in einer weiteren erfindungsgemäßen Ausführungsform eine im Strahlengang der ersten, ebenen Kalibrierwelle und der zweiten, sphärischen Kalibrierwelle angeordnete Verschlussvorrichtung, welche wahlweise entweder die ebene Kalibrierwelle oder die sphärische Kalibrierwelle passieren lässt. Insbesondere umfasst die Verschlussvorrichtung zwei aufeinander abgestimmte Verschlusselemente, welche z.B. jeweils in Gestalt eines Shutters ausgeführt sind. Mit dieser Maßnahme lässt sich bei einer Kalibrierung schnell und unkompliziert jeweils eine Kalibrierwelle zum Kalibrieren auswählen. In weiteren Ausführungsformen kann für eine oder beide Kalibrierwellen ein Verschlusselement, beispielsweise ein Shutter, vorgesehen sein, welcher die jeweilige Kalibrierwelle unabhängig von der anderen Kalibrierwelle blockiert oder passieren lässt.

Eine Ausführungsform des erfindungsgemäßen Verfahrens zum interferometrischen Bestimmen einer Form einer Oberfläche eines Testobjekts umfasst weiterhin die Schritte: Erzeugen mindestens einer auf einen Kalibrierspiegel gerichteten Kalibrierwelle mit ebener oder sphärischer Wellenfront aus der Eingangswelle durch das diffraktive optische Element, Bestimmen von Oberflächenfehlern des reflektiven optischen Elements und des mindestens einen Kalibrierspiegels, Messen einer Wellenfrontdifferenz zwischen dem reflektiven optischen Element und dem Kalibrierspiegel, Bestimmen von Kalibrierkorrekturen aus der gemessenen Wellenfrontdifferenz und den Oberflächenfehlern, und Bestimmen der Form der Oberfläche des Testobjekts aus dem erfassten Interferogramm unter Berücksichtigung der Kalibrierkorrekturen.

Zum Bestimmen von Oberflächenfehlern des reflektiven optischen Elements oder des Kalibrierspiegels kann z.B. ein dem Fachmann bekanntes Drei-Stellungstest-Verfahren verwendet werden. Ein solches Verfahren ist beispielsweise aus DE 198 20 785 A1 bekannt. Dabei wird das jeweilige optische Element in verschiedenen Drehpositionen um die optische Achse und verschiedenen Positionen entlang der optischen Achse des optischen Elements mittels der Erfassungseinheit und dem diffraktiven optischen Elements interferometrisch vermessen. Messungen können z.B. in einer Grundstellung, einer um 180° gedrehten Position und bei einer Katzenaugenposition vorgenommen werden. Aus den erfassten Interferogrammen lässt sich die Oberflächenform absolut bestimmen. Ein weiteres zur Bestimmung der Oberflächenfehler anwendbares Verfahren ist das Dreh-Schiebe-Verfahren (Englisch: shift-rotation method). Dies wird in "Absolute surface figure testing by shift-rotation method using Zernike polynomials", Su et al., Optics Letters, Vol. 37, Issue 15, Seiten 3198-3200 (2012) beschrieben.

Das Messen der Wellenfrontdifferenz erfolgt vorzugsweise durch die Erfassungseinrichtung. Dabei wird ein in der Erfassungsebene durch eine Überlagerung der Referenzwelle mit der Kalibrierwelle erzeugtes Interferogramm erfasst und ausgewertet. Mit diesem Verfahren lässt sich eine hochgenaue Kalibrierung des diffraktiven optischen Elements und der anderen Komponenten der Messvorrichtung durchführen.

Gemäß einer erfindungsgemäßen Ausführungsvariante wird durch das diffraktive optische Element aus der Eingangswelle eine auf einen ersten Kalibrierspiegel gerichtete erste Kalibrierwelle mit einer ebenen Wellenfront sowie eine auf einen zweiten Kalibrierspiegel gerichtete zweite Kalibrierwelle mit einer sphärischen Wellenfront erzeugt, jeweils eine Wellenfrontdifferenz zwischen dem reflektiven optischen Element und dem ersten Kalibrierspiegel bzw. dem zweiten Kalibrierspiegel gemessen und die Kalibrierkorrekturen aus den gemessenen Wellenfrontdifferenzen und den Oberflächenfehlern bestimmt. Zur Messung der Wellenfrontdifferenz kann auch hier die Erfassungseinrichtung der Messanordnung verwendet werden. Bei einer Messung der Wellenfrontdifferenz zwischen erster Kalibrierwelle und Referenzwelle kann ferner ein Blockieren der zweiten Kalibrierwelle durch ein Verschlusselement und umgekehrt vorgesehen sein.

Gemäß einer Ausführungsform umfasst die Messanordnung weiterhin ein reflektives optisches Element und eine Erfassungseinrichtung und auch das reflektive optische Element und die Erfassungseinrichtung weisen bei der Vermessung der Oberflächenform eine Temperatur von kleiner als 25°C auf. In einer weiteren Ausführungsform ist die absolute Messgenauigkeit kleiner als 0,04 nm. Auch kann der Spiegel auf eine vorgegebene Temperatur von über 35°C, insbesondere über 40°C erwärmt werden.

Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:

Fig. 1 ein erstes Ausführungsbeispiel einer erfindungsgemäßen Messanordnung in einer schematischen Veranschaulichung,

Fig. 2 ein zweites Ausführungsbeispiel einer erfindungsgemäßen Messanordnung mit Hitzeschilde und einer Vakuum-Umgebung in einer schematischen Veranschaulichung,

Figuren 3a und 3b jeweils ein Ausführungsbeispiel einer Messanordnung mit einem kippbar bzw. einem verschiebbar gelagerten reflektiven optischen Element in einer schematischen Detailansicht,

Fig. 4 ein drittes Ausführungsbeispiel der Messanordnung mit einem ebenen und einem sphärischen Kalibrierspiegel in einer schematischen Veranschaulichung,

Fig. 5 eine Veranschaulichung eines Ausführungsbeispiels eines erfindungsgemäßen Verfahrens zum Bestimmen einer Oberflächenform mit der Messanordnung nach Fig. 4 in einer schematischen Veranschaulichung,

Fig. 6 ein weiteres Ausführungsbeispiel einer Messanordnung zur interferometrischen Bestimmung einer Oberflächenform in einer schematischen Veranschaulichung,

Fig. 7 ein Ausführungsbeispiel eines Spiegels in einer schematischen Schnittansicht, sowie

Fig. 8 ein Ausführungsbeispiel einer Projektionsbelichtungsanlage mit einem Projektionsobjektiv in einer schematischen Veranschaulichung.

Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden. Zur Erleichterung der Beschreibung ist in einigen Zeichnungen ein kartesisches xyz-Koordinatensystem angegeben, aus dem sich die jeweilige Lagebeziehung der in den Figuren dargestellten Komponenten ergibt.

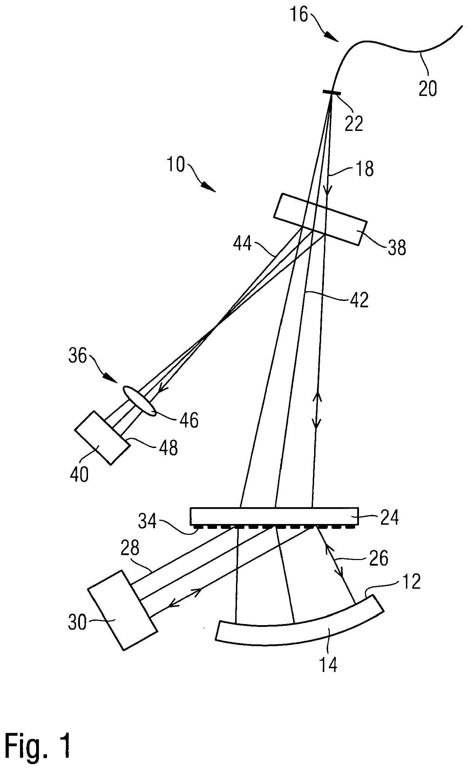

In Fig. 1 wird ein Ausführungsbeispiel einer Messanordnung 10 zur interferometrischen Bestimmung der Form einer optischen Oberfläche 12 eines Testobjekts 14 veranschaulicht. Mit der Messanordnung 10 lässt sich insbesondere eine Abweichung der tatsächlichen Form der Oberfläche 12 von einer Sollform bestimmen. Als Testobjekt 14 kann beispielsweise ein Spiegel eines Projektionsobjektivs für die EUV-Mikrolithographie mit einer nichtsphärischen Oberfläche zur Reflexion von EUV-Strahlung mit einer Wellenlänge von kleiner als 100 nm, insbesondere einer Wellenlänge von etwa 13,5 nm oder etwa 6,8 nm, und einer Spiegeltemperatur von größer als 32°C, insbesondere größer als 35°C oder größer als 40°C vorgesehen sein. Die nicht-sphärische Oberfläche des Spiegels kann eine Freiformoberfläche mit einer Abweichung von jeder rotationssymmetrischen Asphäre von mehr als 5 μm und einer Abweichung von jeder Sphäre von mindestens 1 mm aufweisen. Die vorstehend genannte Spiegeltemperatur entspricht der Betriebstemperatur des Spiegels im Belichtungsbetrieb in einer Projektionsbelichtungsanlage für die Mikrolithographie. Zum Einstellen der Temperatur des Spiegels kann die Messanordnung 10 eine in Fig. 1 nicht dargestellte Heizvorrichtung enthalten.

Die Messanordnung 10 enthält eine Lichtquelle 16 zum Bereitstellen einer ausreichend kohärenten Messstrahlung als Eingangswelle 18. In diesem Ausführungsbeispiel umfasst die Lichtquelle 16 einen Lichtwellenleiter 20 mit einer Austrittsfläche 22. Der Lichtwellenleiter 22 ist an eine in Fig. 1 nicht dargestellte Strahlungsquelle, z.B. in Gestalt eines Laser, angeschlossen. Dazu kann beispielsweise ein Helium-Neon-Laser mit einer Wellenlänge von ungefähr 633 nm vorgesehen sein. Die Beleuchtungsstrahlung kann aber auch eine andere Wellenlänge im sichtbaren oder nicht sichtbaren Wellenlängenbereich elektromagnetischer Strahlung aufweisen. Die Lichtquelle 16 mit dem Lichtwellenleiter 20 stellt lediglich ein Beispiel einer für die Messanordnung verwendbaren Lichtquelle dar. In alternativen Ausführungen kann anstelle des Lichtwellenleiters 20 eine optische Anordnung mit Linsenelementen, Spiegelelementen oder dergleichen zur Bereitstellung einer geeigneten Eingangswelle 18 vorgesehen sein.

Die Messanordnung enthält weiterhin ein diffraktives optisches Element 24 zum Erzeugen einer Prüfwelle 26 und einer Referenzwelle 28 aus der Eingangswelle 18 und ein reflektives optisches Element 30 zur Reflexion der Referenzwelle 28. Das diffraktive optische Element 24 ist als komplex kodiertes CGH ausgebildet und enthält diffraktive Strukturen 34, welche zwei in einer Ebene sich überlagernd angeordnete diffraktive Strukturmuster 34 bilden. Diese beiden diffraktiven Strukturmuster können z.B. durch ein erstes Strukturmuster in Gestalt eines Grundgitters und ein zweites diffraktives Strukturmuster in Gestalt eines Übergitters gebildet werden. Eines der diffraktiven Strukturmuster ist zur Erzeugung der Prüfwelle 26 mit einer zumindest teilweise an die Form der optischen Oberfläche 12 angepassten Wellenfront konfiguriert. Die Erzeugung der Prüfwelle 26 erfolgt dabei durch Beugung der Eingangswelle 18 an dem genannten diffraktiven Strukturmuster in betragsmäßig erster oder höherer Ordnung, wie beispielsweise in erster Beugungsordnung. Die Ausbreitungsrichtung der Prüfwelle 26 ist gegenüber der Ausbreitungsrichtung der Eingangswelle 18 um mindestens 1° verkippt. Das andere diffraktive Strukturmuster erzeugt die Referenzwelle 28 mit einer ebenen Wellenfront. Dies erfolgt durch Beugung der Eingangswelle 18 an dem anderen diffraktiven Strukturmuster in betragsmäßig erster oder höherer Ordnung, wie beispielsweise in erster Beugungsordnung. Die Ausbreitungsrichtung der Referenzwelle 28 ist gegenüber der Ausbreitungsrichtung der Eingangswelle 18 um mindestens 1° verkippt. Das reflektive optische Element 30 ist als ebener Spiegel zur Rückreflexion der Referenzwelle 28 mit ebener Wellenfront ausgebildet. In einer anderen Ausführung kann die Referenzwelle 28 eine sphärische Wellenfront aufweisen und das reflektive optische Element als sphärischer Spiegel ausgebildet sein.

Ferner enthält die Messanordnung 10 eine Erfassungseinrichtung 36 mit einem Strahlteiler 38 zum Herausführen der Kombination aus der reflektierten Prüfwelle 26 und der reflektierten Referenzwelle 28 aus dem Strahlengang der Eingangswelle 18 und eine Interferometerkamera 40 zum Erfassen eines durch Überlagerung der Prüfwelle 26 mit der Referenzwelle 28 erzeugten Interferogramms.

Im Folgenden werden die Funktionsweise und das Zusammenwirken der Komponenten der Messvorrichtung 10 zusammen mit einem entsprechenden Ausführungsbeispiel eines Verfahrens zur interferometrischen Bestimmung der Oberflächenform des Testobjekts 14 beschrieben.

Die von der Lichtquelle 16 bereitgestellte Beleuchtungsstrahlung tritt aus der Austrittsfläche 22 des Lichtwellenleiters 20 als Eingangswelle 18 mit einer sphärischen Wellenfront aus und breitet sich divergent entlang einer auf das diffraktive optische Element 24 gerichteten Ausbreitungsachse 42 aus. Dabei durchläuft die Eingangswelle 18 zunächst den Strahlteiler 38 und anschließend das diffraktive optische Element 24. In alternativen Ausführungen kann zwischen dem Strahlteiler 38 und dem diffraktiven optischen Element 24 ein Kollimator zur Erzeugung einer Eingangswelle 18 mit ebener Wellenfront vorgesehen sein.

Das als komplex kodiertes CGH ausgebildete diffraktive optische Element 24 erzeugt in Transmission durch Beugung an einer der überlagernd angeordneten diffraktiven Strukturmuster aus der Eingangswelle 18 die auf die Oberfläche 12 des Testobjekts 14 gerichtete Prüfwelle 26 mit einer an eine Sollform der Oberfläche 12 angepassten Wellenfront. Bei dieser Transformation wird die Wellenfront derart angepasst, dass die Prüfwelle an jedem Ort einer Oberfläche in Sollform senkrecht auftrifft und in sich zurückreflektiert wird.

Die Prüfwelle 26 breitet sich in Richtung des Testobjekts 14 aus und trifft nach der Erzeugung am diffraktiven optischen Element 24 als nächstes auf die optische Oberfläche 12 des Testobjekts 14. Von der Oberfläche 12 wird die Prüfwelle 26 zum diffraktiven optischen Element 24 zurück reflektiert und beim Durchtreten der diffraktiven Strukturen 34 erneut gebeugt. Die Beugungsordnung ist dabei dieselbe wie die bei der Erzeugung der Prüfwelle 26 durch Beugung der Eingangswelle 18 verwendete Beugungsordnung, beispielsweise die erste Beugungsordnung. Durch die erneute Beugung der Prüfwelle am optischen Element 24 erfolgt eine Rücktransformation der reflektierten Prüfwelle 26 in eine annähernd sphärische Welle, wobei deren Wellenfront durch Abweichungen der Oberfläche 12 des Testobjekts 14 von der Sollform entsprechende Abweichungen von einer sphärischen Wellenfront aufweist. Diese Abweichung ist jedoch nicht größer als 10 μm.

Weiterhin erzeugt das diffraktive optische Element 24 in Transmission durch Beugung an dem anderen der diffraktiven Strukturmuster aus der Eingangswelle 18 die auf das reflektive optische Element 30 gerichtete Referenzwelle 28. Dabei weist die Referenzwelle 28 eine von der Ausbreitungsrichtung der Prüfwelle 26 abweichende Ausbreitungsrichtung und eine an die Oberflächenform des reflektiven optischen Elements 30 angepasste Wellenfront auf. In diesem Ausführungsbeispiel ist das reflektive optische Element 30 als ebener Spiegel ausgebildet und die Referenzwelle weist durch die Transformation am diffraktiven optischen Element 24 eine ebene Wellenfront auf. In anderen Ausführungen kann ein konvexer oder konkaver sphärischer Spiegel als reflektives optisches Element und eine entsprechende Anpassung der Wellenfront der Referenzwelle vorgesehen sein.

Die Referenzwelle 30 trifft nach der Erzeugung am diffraktiven optischen Element 24 als nächstes auf das reflektive optische Element 30 und wird von diesem in sich zurück reflektiert. Dabei befinden sich weder im Strahlengang der Referenzwelle 28 noch im Strahlengang der Prüfwelle 26 weitere optische Elemente. Die reflektierte Referenzwelle 28 durchläuft wiederum das diffraktive optische Element 24 und wird erneut gebeugt. Die Beugungsordnung ist dabei dieselbe wie die bei der Erzeugung der Referenzwelle 28 durch Beugung der Eingangswelle 18 verwendete Beugungsordnung, beispielsweise die erste Beugungsordnung. Durch die erneute Beugung der reflektierten Referenzwelle 28 am optischen Element 24 erfolgt eine Rücktransformation der reflektierten Referenzwelle 28 in eine sphärische Welle. In einer alternativen Ausführung mit einem Kollimator im Strahlengang der Eingangswelle 18 zur Erzeugung einer Eingangswelle mit ebener Wellenfront und einem ebenen Spiegel als reflektives optisches Element 30 ist keine Anpassung der Wellenfront der Referenzwelle 28 durch das diffraktive optische Element 24 notwendig. In einer weiteren, zeichnerisch nicht dargestellten, alternativen Ausführung mit einem Kollimator im Strahlengang der Eingangswelle 18 zur Erzeugung einer Eingangswelle mit ebener Wellenfront und einem ebenen Spiegel als reflektives optisches Element 30 erfolgt nur eine Anpassung der Richtung der ebenen Wellenfront der Referenzwelle 28 durch das diffraktive optische Element 24.

Das diffraktive optische Element 24 dient somit auch zur Überlagerung der reflektierten Prüfwelle 26 mit der reflektierten Referenzwelle 28. Beide Wellen treffen als konvergente Strahlen 44 auf den Strahlteiler 38 und werden von diesem in Richtung der Interferometerkamera 40 reflektiert. Beide konvergente Strahlen 44 durchlaufen ein Okular 46 und treffen schließlich auf eine Erfassungsebene 48 der Interferometerkamera 40. Die Interferometerkamera 40 kann beispielsweise als CCD-Sensor ausgebildet sein und erfasst ein durch die interferierenden Wellen erzeugtes Interferogramm. Im Fokus der konvergenten Strahlen 44 kann eine in Fig. 1 nicht dargestellte Blende als Raumfilter zur Reduzierung von Streustrahlung angeordnet sein. Die Situation der reflektierten Prüfwelle 26 und der reflektierten Referenzwelle 28 nach der erneuten Beugung am diffraktiven optischen Element 24 kann auch dadurch beschrieben werden, dass die beiden reflektierten Wellen 26 und 28 nach der erneuten Beugung eine gemeinsame Rücklaufwelle bilden. Die Ausbreitungsrichtung der Rücklaufwelle ist gemäß einer Ausführungsform gegenüber der umgekehrten Ausbreitungsrichtung der Eingangswelle 18 im Bereich vor dem diffraktiven optischen Element 24 um weniger als 1° verkippt.

Aus dem erfassten Interferogramm bestimmt eine in Fig. 1 nicht dargestellte Auswerteeinrichtung der Messanordnung 10 die tatsächliche Form der optischen Oberfläche 12 des Testobjekts 14. Dazu verfügt die Auswertungseinrichtung über eine geeignete Datenverarbeitungseinheit und verwendet entsprechende, dem Fachmann bekannte Berechnungsverfahren. Alternativ oder zusätzlich kann die Messvorrichtung 10 einen Datenspeicher oder eine Schnittstelle zu einem Netzwerk enthalten, um eine Bestimmung der Oberflächenform mittels des gespeicherten bzw. über das Netzwerk übertragenen Interferogramms durch eine externe Auswertungseinheit zu ermöglichen. Die Auswertungseinheit berücksichtigt bei der Bestimmung der Oberflächenform insbesondere ein Ergebnis einer Kalibrierung des diffraktiven Elements 24 bzw. des komplex kodierten CGHs. Ein Ausführungsbeispiel einer solchen Kalibrierung wird weiter unten beschrieben.

Durch die Verwendung der miteinander überlagerten diffraktiven Strukturmuster des diffraktiven optischen Elements 24 zur Erzeugung der Prüfwelle 26 und der Referenzwelle 28 in Transmission und zur Überlagerung dieser Wellen nach Reflexion am Testobjekt 14 bzw. am reflektiven optischen Element 30 lassen sich insbesondere gegenüber der Umgebung wärmere Testobjekte hochgenau vermessen. Dabei kann die Messanordnung 10 und insbesondere das diffraktive optische Element 24 bei Raumtemperatur von kleiner als 25°C, insbesondere von etwa 22°C, betrieben werden. Durch Wärmestrahlung des warmen Testobjekts 14 verursachte Inhomogenitäten im diffraktiven optischen Element 24 wirken sich gleichermaßen auf die Referenzwelle 28 und die Prüfwelle 26 aus und heben sich bei der interferometrischen Messung mit der Messanordnung 10 auf. Durch Wärmestrahlung des warmen Testobjekts 14 verursachte Unebenheiten im diffraktiven optischen Element 24 wirken sich ähnlich auf die Referenzwelle 28 und die Prüfwelle 26 aus, wodurch die Wirkung der Unebenheiten auf die interferometrische Messung mit der Messanordnung 10 reduziert wird.

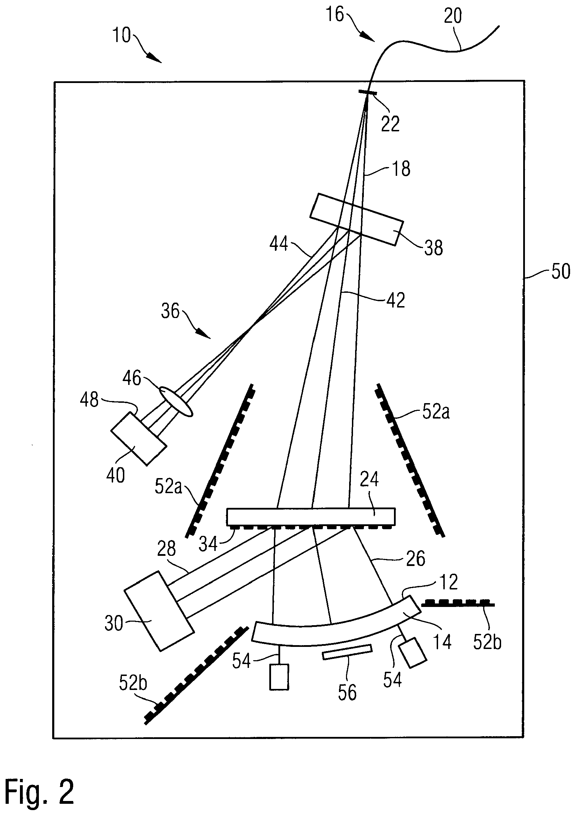

Fig. 2 veranschaulicht ein zweites Ausführungsbeispiel einer Messanordnung 10. Die Messanordnung 10 entspricht weitgehend der Messanordnung nach Fig. 1, ist aber zusätzlich in einer Vakuumkammer 50 angeordnet. Die Vakuumkammer 50 ist mit Luft unter einem Druck von kleiner als 100 mbar gefüllt. Ein solches Vakuum weist nur eine geringe temperaturabhängige Änderung des Brechungsindex auf. Alternativ kann die Vakuumkammer 50 mit Helium unter Atmosphärendruck gefüllt sein. Auch bei Helium tritt nur eine geringe temperaturabhängige Änderung des Brechungsindex auf.

Weiterhin umfasst die Messanordnung 10 mehrere Hitzeschilde 52. Exemplarisch sind zwei derartige Hitzeschilde 52a bei dem diffraktiven optischen Element 24 angeordnet und schützen dieses vor Wärmestrahlung von Wärmequellen. Entsprechend können auch bei dem reflektiven optischen Element 30 Hitzeschilde vorgesehen sein. Zwei weitere Hitzeschilde 52b sind in der Nähe von Wärmequellen, wie etwa einem Positionierungsantrieb 54 oder einer Heizvorrichtung 56 für das Testobjekt 14 angeordnet. Die Hitzeschilde 52 weisen jeweils auf einer Seite eine Beschichtung aus einem Wärmestrahlung absorbierenden Material und auf der anderen Seite eine Beschichtung aus einem Wärmestrahlung stark reflektierenden Material, wie beispielsweise Gold, auf. Ferner sind die Hitzeschilde 52 jeweils so angeordnet, dass die Seite mit der wäremeabsorbierenden Beschichtung zum diffraktiven optischen Element 24 oder zum reflektiven optischen Element 30 der Messvorrichtung 10 zeigt.

Die Heizvorrichtung 56 ermöglicht ein Erwärmen des Testobjekts 14 auf eine vorgegebene Temperatur, wie beispielsweise die vorstehend erwähnte vorgesehene Betriebstemperatur des Testobjekts 14 im Belichtungsbetrieb in einer Projektionsbelichtungsanlage für die Mikrolithographie. Insbesondere die Heizvorrichtung 56 zum Beheizen des Testobjekts 14 ist auf eine vorgegebene Temperatur von größer als 32°C ausgelegt. Dabei regelt die Heizvorrichtung 56 die Temperatur des Testobjekts mindestens während der Dauer einer Messung auf die vorgegebene Temperatur und enthält hierfür z.B. geeignet ausgebildete Temperatursensoren.

Weiterhin weisen die Substrate des diffraktiven optischen Elements 24 und des reflektiven optischen Elements 30 ein optisches Material mit einem Wärmeausdehnungskoeffizient von betragsmäßig höchstens $0{,}5 \times 10^{-6} K^{-1}$ im Temperaturbereich von 5°C bis 35°C auf. Insbesondere können die Substrate jeweils ein optisches Material mit einem Wärmeausdehnungskoeffizient von betragsmäßig höchstens $0{,}05 \times 10^{-6} K^{-1}$ im Temperaturbereich von 0°C bis 50°C aufweisen. Beispiele für ein derartiges optisches Material umfassen Zerodur® oder ULE®-Glas (Ultra Low Expansion Glas).

Bei einer Erwärmung des Substrats eines CGHs sind insbesondere die Wärmeausdehnung und die Temperaturabhängigkeit des Brechungsindex zu berücksichtigen. Eine Wärmeausdehnung parallel zur Ebene der diffraktiven Strukturen 34 führt im Wesentlichen zu einer lateralen Verschiebung einzelner Strukturen, welche insbesondere bei hohen Streifendichten zusätzliche Phasenbeiträge verursachen. Bei Streifendichten von mehr als 800 Linien/mm wird daher vorzugsweise für das diffraktive optische Element 24 ein Substratmaterial mit einem sehr kleinen Wärmeausdehnungskoeffizient, wie die vorstehend erwähnten Zerodur® und ULE®-Glas (Ultra Low Expansion Glas) verwendet.

Vertikal zur Ebene der diffraktiven Strukturen 34 kann sich durch Erwärmung insbesondere die optische Weglänge durch das diffraktive optische Element 24 verändern. Dies geschieht aufgrund einer vertikalen Ausdehnung des diffraktiven optischen Elements 24 oder aufgrund eines temperaturabhängigen Brechungsindex des Substrats des diffraktiven optischen Elements 24. Dieser Effekt dominiert bei kleinen Streifendichten und oft bei einer Wellenlänge der Eingangswelle 18 im sichtbaren Spektralbereich. In diesem Fall wird für das Substrat des diffraktiven optischen Elements 24 vorzugsweise ein athermales optisches Material, wie beispielsweise Caciumfluorid ($CaF_2$) oder P-PK53, ein Produkt der Schott AG, verwendet. Als athermales optisches Material wird ein Material bezeichnet, bei dem sich temperaturbedingte Änderungen des Brechungsindex und eine Ausdehnung des Materials in ihrer optischen Wirkung zumindest teilweise kompensieren. Diese Materialien weisen eine kleine thermooptische Konstante $G = \alpha*(n-1)+dn/dT$ mit Wärmeausdehnungskoeffizient $\alpha$, Brechungsindex $n$ und Temperaturkoeffizient der Brechzahl $dn/dT$ auf. Somit ist die optische Weglänge in diesen Materialien weitgehend unabhängig von der Temperatur. In weiteren Ausführungsbeispielen kann das Substrat auch aus mehreren Schichten unterschiedlicher Materialien aufgebaut sein, z.B. abwechselnd aus Quarz und $CaF_2$, um eine athermale Wirkung zu erreichen. Dabei kann eine Abstimmung der Schichtdicken in Abhängigkeit von der Streifendichte erfolgen, um die oben genannten Effekte durch laterale und vertikale Ausdehnung zu minimieren. $CaF_2$ weist ferner eine hohe Wärmeleitfähigkeit auf, wodurch bei lokalen Temperaturänderungen eine schnelle Thermalisierung erfolgt. In Tabelle 1 sind einige thermale Eigenschaften oben genannter Materialien aufgeführt.

Tabelle 1: Thermale Eigenschaften

| Material | $dn/dT_{absolut}$ (+20/+40 °C, $\lambda \approx 546$ nm) [$10^{-6}$ K$^{-1}$] | Wärmeleitzahl [W/mK] | $\alpha$ *(-30/+70 °C) **(-0/+50 °C) [$10^{-6}$ K$^{-1}$] | G ($\lambda \approx 546$ nm) [$10^{-6}$ K$^{-1}$] |
|---|---|---|---|---|
| $CaF_2$ | -11,40 | 9,71 | 18,43* | -3,38 |
| P-PK53 | -6,50 | 0,64 | 13,31* | 0,54 |
| Quarz | 10,00 | 1,38 | 0,5* | 10,23 |
| Zerodur® | 13,40 | 1,38 | 0,05** | 13,42 |

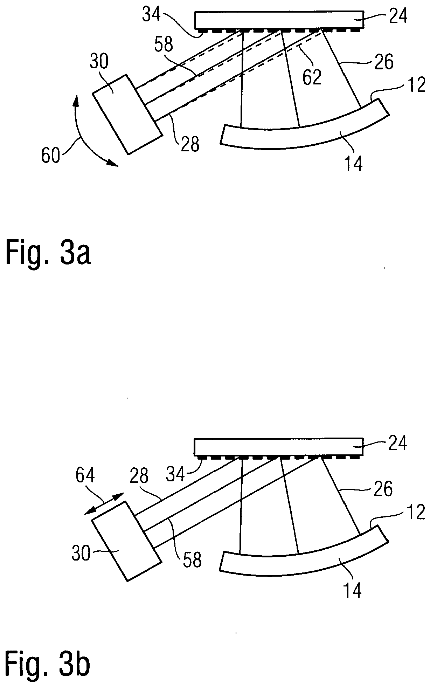

Fig. 3a veranschaulicht den das diffraktive optische Element 24 und das reflektive optische Element 30 umfassenden unteren Abschnitt der Messanordnung 10 gemäß Fig. 1 in einer Ausführungsvariante mit einem kippbar gelagerten reflektiven optischen Element 30 in einer schematischen Detailansicht. Das reflektive optische Element 30 ist um eine Achse senkrecht zur optischen Achse bzw. Ausbreitungsrichtung 58 der Referenzwelle 28 drehbar gelagert. Durch eine Drehung (Pfeil 60) des reflektiven optischen Elements 30 erfolgt eine Kippung der reflektierten Referenzwelle 62 gegenüber der reflektierten Prüfwelle 26. Für eine solche Drehung kann z.B. ein Piezo-Element vorgesehen sein. Die Messanordnung 10 lässt sich so für eine Vielstreifeninterferometrie bzw. eine sogenannte Displaced-Measurement-Interferometries (DMI) verwenden. Die Neigung der reflektierten Referenzwelle 62 gegenüber der reflektierten Prüfwelle 26 führt in der Erfassungsebene 48 durch die ortsabhängige Phasenverschiebung zu einem Streifenmuster, welches eine räumliche Trägerwelle darstellt. Dabei ist die Frequenz der Trägerwelle von dem Neigungswinkel abhängig. Lokale Phasenverschiebungen der Prüfwelle 26 durch Abweichungen der Oberfläche 12 des Testobjekts 14 von einer Sollform bewirken eine räumliche Modulation der Trägerwelle bzw. des Streifenmusters. Die Form der Oberfläche 12 lässt sich aus der Modulation der Trägerwelle hochgenau berechnen. Alternativ zum Kippen des reflektiven optischen Elements 30 kann eine Neigung der reflektierten Referenzwelle 62 gegenüber der Prüfwelle 26 auch durch eine entsprechende Ausbildung der die Referenzwelle 28 erzeugenden diffraktiven Strukturmusters des diffraktiven optischen Elements 24 erfolgen. Eine Vielstreifeninterferometrie wird beispielsweise in US 5,361,312 beschrieben.

Fig. 3b zeigt den das diffraktive optische Element 24 und das reflektive optische Element 30 umfassenden unteren Abschnitt der Messanordnung 10 gemäß Fig. 1 in einer Ausführungsform mit einem ebenen Spiegel als reflektives optisches Element 30, welcher entlang der optischen Achse bzw. Ausbreitungsrichtung 58 der Referenzwelle 26 verschiebbar gelagert ist (Pfeil 64). Insbesondere ist das reflektive optische Element 30 schrittweise in Bruchteilen der Wellenlänge der Referenzwelle 26 oder kontinuierlich verschiebbar. Hierfür kann beispielsweise ein Piezo-Element eingesetzt werden. Mit dieser Messanordnung 10 kann eine Phasenverschiebeinterferometrie durchgeführt werden. Dabei werden nacheinander bei verschiedenen Positionen des reflektiven optischen Elements 30 und somit unterschiedlichen Phasenverschiebungen der Referenzwelle 26 Interferogramme in der Erfassungsebene 48 erfasst. Die Phasenverschiebung ist in der Erfassungsebene 48 ortsunabhängig und ändert sich mit der Zeit. Statt der oben erwähnten räumlich modulierten Trägerwelle wird eine zeitlich modulierte Trägerwelle erzeugt. Aus mehreren Interferogrammen lässt sich aus den an einem Punkt erfassten Intensitäten die Phasenverschiebung der Prüfwelle 26 an diesem Punkt eindeutig bestimmen. Auch mit diesem Verfahren lässt sich daher die Oberfläche 12 des Testobjekts 14 hochgenau vermessen. Eine Phasenverschiebeinterferometrie wird ebenfalls in US 5,361,312 beschrieben.

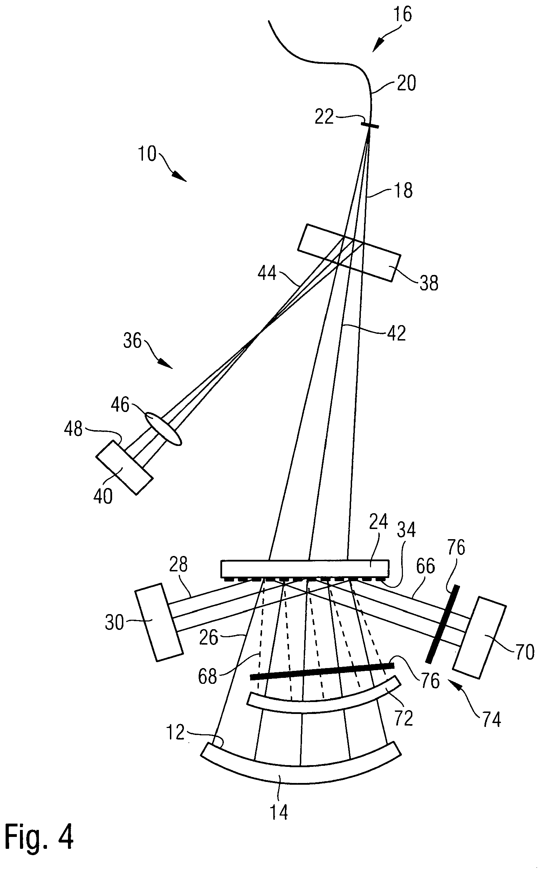

Fig. 4 veranschaulicht eine weitere Messanordnung 10 in einer schematischen Ansicht. Die Messanordnung 10 enthält im Gegensatz zur Messanordnung gemäß Fig. 1 ein komplex kodiertes CGH als diffraktives optisches Element 24, welches in Transmission durch Beugung zusätzlich zur Prüfwelle 26 und zur Referenzwelle 28 eine Kalibrierwelle 66 mit ebener Wellenfront und eine Kalibrierwelle 68 mit sphärischer Wellenfront aus der Eingangswelle 18 erzeugt. Sowohl die ebene Kalibrierwelle 66 als auch die sphärische Kalibrierwelle 68 weisen jeweils eine von allen anderen Wellen abweichende Ausbreitungsrichtung auf. Das diffraktive optische Element 24 kann hierfür diffraktive Strukturen 34 umfassen, welche vier in einer Ebene überlagert angeordnete diffraktive Strukturmuster bilden aufweisen. Ein solches diffraktives optisches Element wird beispielsweise in DE 10 2012 217 800 A1 offenbart. Hier werden die unterschiedlichen diffraktiven Strukturmuster durch einzelne Phasenfunktionen eines komplex kodierten Phasengitters gebildet.

Im Strahlengang der ebenen Kalibrierwelle 66 ist ein planer Kalibrierspiegel 70 angeordnet. Der plane Kalibrierspiegel 70 reflektiert die ebene Kalibrierwelle 66 in sich zurück. Weiterhin ist im Strahlengang der sphärischen Kalibrierwelle 68 ein sphärischer Kalibrierspiegel 72 angeordnet. Der sphärische Kalibrierspiegel 72 ist derart ausgebildet, dass er die sphärische Kalibrierwelle 68 in sich zurück reflektiert. Im Strahlengang der ebenen Kalibrierwelle 66 und der sphärischen Kalibrierwelle 68 ist weiterhin eine Verschlussvorrichtung 74 vorgesehen, welche wahlweise entweder die ebene Kalibrierwelle 66 oder die sphärische Kalibrierwelle 68 passieren lässt. Dazu enthält die Verschlussvorrichtung 74 einen oder zwei geeignet ausgebildete Shutter 76. Auf diese Weise kann bei einer Kalibrierung schnell zwischen der ebenen Kalibrierwelle 66 und der sphärischen Kalibrierwelle 68 gewechselt werden.

Bei einer Kalibrierung ist in der in Fig. 4 gezeigten Ausführung das Testobjekt 14 aus dem Strahlengang der Prüfwelle 26 entfernt. Entsprechend ist bei einer Vermessung des Testobjekts 14 der sphärische Kalibrierspiegel 72 aus dem Strahlengang der sphärischen Kalibrierwelle 68 entfernt. In einer alternativen Ausbildung kann bei geeigneter Ausbildung des Testobjekts 14, des sphärischen Kalibrierspiegels 72 und des diffraktiven optischen Elements 24 der sphärische Kalibrierspiegel 72 während der Vermessung des Testobjekts 14 in seiner Position verbleiben. In diesem Fall wird bei der Vermessung des Testobjekts 14 die sphärische Kalibrierwelle 68 ebenso wie die ebene Kalibrierwelle 66 durch die Verschlussvorrichtung 74 blockiert. Eine Kalibrierung des diffraktiven optischen Elements 24 mit zwei Kalibrierwellen 66, 68 ist sehr genau möglich. Damit lässt sich mit der Messvorrichtung 10 gemäß Fig. 4 eine hochgenaue Messung der Oberflächenform von Freiformflächen, insbesondere mit einer absoluten Messgenauigkeit von kleiner als 0,04 nm durchführen.

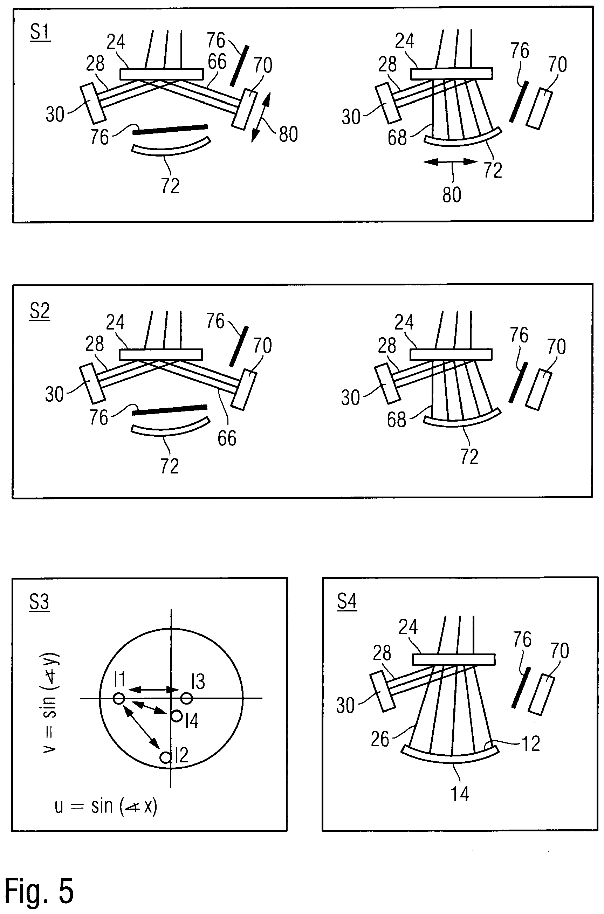

Fig. 5 zeigt ein Ausführungsbeispiel eines erfindungsgemäßen Verfahrens zum Bestimmen einer Oberflächenform des Testobjekts 14 mit der Messanordnung 10 nach Fig. 4 in einer schematischen Veranschaulichung. Einzelne Schritte sind in Fig. 5 eingerahmt. Da die Messanordnung 10 zur Erzeugung einer Referenzwelle das diffraktive optische Element 24 verwendet und somit kein Fizeau-Element enthält, ist es notwendig, für eine Kalibrierung das als planer Referenzspiegel ausgebildete reflektive optische Element 30, den planen Kalibrierspiegel 70 und den sphärischen Kalibrierspiegel 72 gegeneinander zu vermessen. In diesem Ausführungsbeispiel wird das reflektive optische Element 30 bei einer Vermessung des Testobjekts 14 zur Rückreflektion der Referenzwelle 28 verwendet. Alternativ ist auch eine Verwendung des planen Kalibrierspiegels 70 oder des sphärischen Kalibrierspiegels 72 als Referenzspiegel bei einer Messung möglich.

Zur Bestimmung der Oberfläche 12 des Testobjekts 14 wird zunächst eine hochgenaue Kalibrierung der Fehler des diffraktiven optischen Elements 24 durchgeführt. Dazu werden in einem ersten Schritt S1 die Oberflächenfehler R1 des als planer Referenzspiegel ausgeführten reflektiven optischen Elements 30, die Oberflächenfehler R2 des planen Kalibrierspiegels 70 und die Oberflächenfehler R3 des sphärischen Kalibrierspiegels 72 bestimmt. Hierfür kann beispielsweise ein Dreh-Schiebe-Verfahren, wie es etwa in "Absolute surface figure testing by shift-rotation method using Zernike polynomials", Su et al., Optics Letters, Vol. 37, Issue 15, Seiten 3198-3200 (2012) beschrieben wird, verwendet werden. Dabei wird das jeweilige optische Element in verschiedenen Drehpositionen bzgl. dessen optischer Achse und verschiedenen Positionen entlang der optischen Achse mittels der Erfassungseinrichtung 36 interferometrisch vermessen. Alternativ kann bei einem konvexen sphärischen Kalibrierspiegel 72 auch das in "Absolute testing of the reference surface of a Fizeau interferometer through even/odd decompositions", R. Schreiner et al., Applied Optics, Vol. 47, No. 32, 10 November 2008 beschriebene Verfahren verwendet werden. In Fig. 5 ist die Bestimmung der Oberflächenfehler des planen Kalibrierspiegels 70 und des sphärischen Kalibrierspiegels 72 durch den Pfeil 80 schematisch angedeutet. Dabei lassen die Shutter 76 jeweils nur die entsprechende Kalibrierwelle 66 bzw. 68 passieren.

In einem zweiten Schritt S2 wird anschließend mit der Erfassungseinrichtung 36 die Wellenfrontdifferenz dWFR21 zwischen der am planen Kalibrierspiegel 70 reflektierten Kalibrierwelle 66 und der am planen Referenzspiegel 30 reflektierten Referenzwelle 28 gemessen. Dabei lassen die Shutter 76 nur die ebene Kalibrierwelle 66 passieren und blockieren die sphärische Kalibrierwelle 68. Entsprechend wird die Wellenfrontdifferenz dWFR31 zwischen der am sphärischen Kalibrierspiegel 72 reflektierten Kalibrierwelle 68 und der am planen Referenzspiegel 30 reflektierten Referenzwelle 28 gemessen. Dabei wird die ebene Kalibrierwelle 66 von dem Shutter 76 blockiert. Die Wellenfrontdifferenzen setzen sich aus den jeweiligen Oberflächenfehlern R1 und R2 bzw. R1 und R3 und den entsprechenden Interferometerfehlern I1 für den planen Referenzspiegel 30, I2 für den planen Kalibrierspiegel 70 und I3 für den sphärischen Kalibrierspiegel 72 zusammen. Die Interferometerfehler I1, I2 und I3 beschreiben den systematischen Fehler der Messanordnung 10 und werden im Wesentlichen durch Gitterfehler des diffraktiven optischen Elements 24 verursacht. Es gilt:

$$I2 - I1 = dWFR21 - R2 - R1 \quad \text{und} \quad I3 - I1 = dWFR31 - R3 - R1$$

Die Interferometerfehler I1, I2 und I3 bezeichnen eine jeweilige Phasenabweichung der von den jeweiligen optischen Elementen reflektierten Strahlen von der idealen Wellenfront.So bezeichnet I1 die Phasenabweichung der vom planen Referenzspiegel 39 reflektierten Referenzwelle 28, I2 die Richtungsabweichung der vom planen Kalibrierspiegel 70 reflektierten Kalibrierwelle 66 und I3 die Richtungsabweichung der vom sphärischen Kalibrierspiegel 72 reflektierten Kalibrierwelle 68.

Die Interferometerfehler I1, I2 und I3 können daher durch jeweilige Koordinaten im Richtungsraum, welcher durch die Koordinatenachsen u und v aufgespannt wird, dargestellt werden, wie in der dem Schritt S3 zugeordneten Zeichnung von Fig. 5 veranschaulicht. Die Koordinatenachsen u und v sind dabei der Sinus des Winkels entsprechender Strahlen nach dem diffraktiven optischen Element 24 und stellen somit Pupillenkoordinaten dar. In Schritt S3 wird in jedem lokalen Punkt auf dem diffraktiven Element 24 eine Ausgleichsebene durch die jeweiligen Punkte I1, I2, I3 im Richtungsraum bestimmt. Die Koordinatenwerte der Punkte I1, I2 und I3 lassen aus dem optischen Design des diffraktiven optischen Elements 24 bestimmen. Mit der Wahl des planen Referenzspiegels 30 als Referenzspiegel für eine Messung kann der Interferenzfehler I1 auf I1 = 0 gesetzt werden. Eine Ausgleichsebene liefert schließlich den gesuchten Interferometerfehler I4 als Kalibrierkorrektur für das Testobjekt 14:

$$I4 = f(u1, v1, I1=0, u2, v2, I2, u3, v3, I3, u4, v4) + Rest$$

Als Rest werden hier nicht lineare Korrekturen bezeichnet, da elektromagnetische Gitterberechnungen zeigen, dass das lineare Modell nur eine Näherung darstellt. In Schritt S4 wird schließlich eine Messung der Oberflächenform des Testobjekts 14 durchgeführt. Dazu wird der sphärische Kalibrierspiegel 72 entfernt, das Testobjekt 14 in der Messanordnung 10 positioniert und die ebene Kalibrierwelle 66 durch den Shutter 76 blockiert. Bei der Messung wird mit der Erfassungseinrichtung 36 die Wellenfrontdifferenz dWFR41 zwischen der Prüfwelle 26 und der Referenzwelle 28 gemessen. Für R4 als Oberflächenfehler des Testobjekts und somit Abweichung von der Sollform gilt:

$$R4 = dWFR41 - (I4 - I1) \quad (\text{mit } I1 = 0)$$

Die Abweichung der Oberfläche 12 des Testobjekts 14 von der Sollform und somit die Form der Oberfläche 12 wird durch eine Korrektur der interferometrischen Messung mit dem durch die Kalibrierung bestimmten Interferometerfehler I4 hochgenau bestimmt.

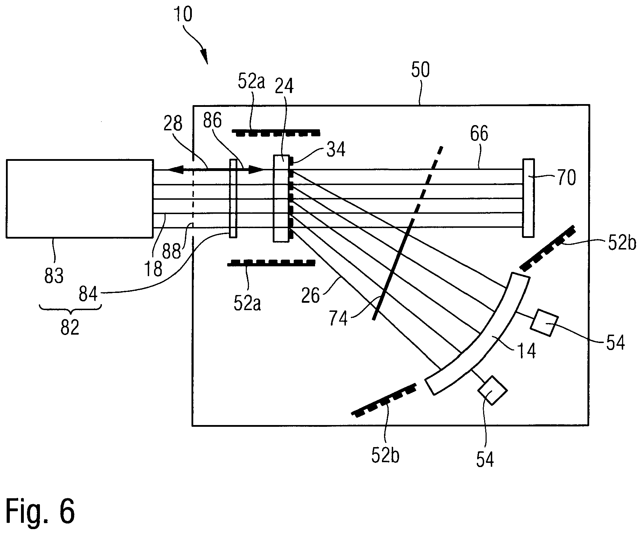

Fig. 6 zeigt eine nicht beanspruchte interferometrische Messanordnung 10 zum Bestimmen der Form der Oberfläche 12 eines Testobjekts 14. Insbesondere ermöglicht die Messvorrichtung 10 eine Kalibrierung während eines Messvorgangs und eignet sich somit auch zur Vermessung von gegenüber der Umgebung wärmeren Testobjekten 14, wie z.B. EUV-Spiegeln bei Betriebstemperatur. Die Messanordnung 10 umfasst ein Interferometer 82 mit einem Fizeau-Element 84, ein diffraktives optisches Element 24 mit einem CGH und einen planen Kalibrierspiegel 70.

Das Interferometer 82 ist als Fizeau-Interferometer ausgeführt und umfasst ein Einstrahl-/Detektionsmodul 83 sowie das Fizeau-Element 84. Der Aufbau und die Funktionsweise eines solchen Interferometers sind dem Fachmann bekannt. Insbesondere enthält das Einstrahl-/Detektionsmodul 83 eine Lichtquelle zur Erzeugung einer für interferometrische Messungen ausreichend kohärenten Beleuchtungsstrahlung. Die Beleuchtungsstrahlung wird z.B. durch einen Kollimator zu einem kollimierten Strahl mit ebener Wellenfront als Eingangswelle 18 ausgebildet. Die Eingangswelle 18 trifft auf das Fizeau-Element 84. Ein Anteil der Eingangswelle 18 wird als Referenzwelle 28 von einer Fizeaufläche des Fizeau-Elements 84 zurückreflektiert. Ein anderer Anteil der Eingangswelle 18 breitet sich als Messwelle 86 weiter aus.

Die Messwelle 86 durchläuft anschließend das einfach kodierte CGH des diffraktiven optischen Elements 24. Das diffraktive optische Element 24 erzeugt aus der Messwelle 86 in 0. Beugungsordnung eine Kalibrierwelle 66 mit ebener Wellenfront und in 1. Beugungsordnung eine Prüfwelle 26 mit einer an eine Sollform der Oberfläche 12 des Testobjekts 14 angepassten Wellenfront. Im Strahlengang der Prüfwelle 26 ist das Testobjekt 14 angeordnet. In einem Messmoduls wird die Prüfwelle 26 von der Oberfläche 12 zurückreflektiert. Im Strahlengang der Kalibrierwelle 66 ist der plane Kalibrierspiegel 70 angeordnet. Die zurückreflektierte Prüfwelle 26 läuft durch das diffraktive optische Element 24 und das Fizeau-Element 84 zurück in das Interferometer 82 und wird dort mit der Referenzwelle 28 überlagert. Ein dabei erzeugtes Interferogramm wird von einer Interferometerkamera erfasst. In alternativen Ausführungen kann als Interferometer auch ein Michelson- oder ein Twyman-Green-Interferometer oder ein anderes geeignetes Interferometer verwendet werden.

In einem Kalibriermodus wird die Kalibrierwelle 66 von dem planen Kalibrierspiegel 70 in sich zurück reflektiert. Im Strahlengang der Prüfwelle 26 und der Kalibrierwelle 66 ist weiterhin eine Verschlussvorrichtung 74 angeordnet, welche wahlweise entweder die Prüfwelle 26 für eine Messung oder die Kalibrierwelle 66 für eine Kalibrierung passieren lässt. Hierfür kann z.B. ein Shutter oder zwei aufeinander abgestimmte Shutter verwendet werden.

Bei einer Messung läuft die von der Oberfläche 12 des Testobjekts 14 reflektierte Prüfwelle 26 in das Interferometer 82 zurück und wird zur Bestimmung der Oberflächenform durch Überlagerung mit der Referenzwelle 28 vermessen. Entsprechend läuft bei einer Kalibrierung die vom planen Kalibrierspiegel 70 reflektierte Kalibrierwelle 66 in das Interferometer 82 zurück und wird zur Kalibrierung des diffraktiven optischen Elements 24 vermessen. Mit der Verschlussvorrichtung 74 lässt sich während eines Messbetriebs sehr schnell in den Kalibriermodus umschalten. Auf diese Weise können durch das warme Testobjekt 14 verursachte Änderungen der optischen Eigenschaften des diffraktiven optischen Elements 24 während des Betriebs erfasst und bei einer Auswertung einer Oberflächenvermessung des Testobjekts 14 berücksichtigt werden.

In einem alternativen Ausführungsbeispiel ist anstelle des einfach kodierten CGHs ein komplex kodiertes CGH als diffraktives optisches Element 24 zur Erzeugung einer Kalibrierwelle mit sphärischer Wellenfront vorgesehen. Die sphärische Kalibrierwelle wird von einem konvexen sphärischen Kalibrierspiegel zurückreflektiert. Ein solcher Spiegel nimmt weniger Platz als der plane Kalibrierspiegel ein. Die Messanordnung 10 lässt sich damit raumsparend realisieren. Ferner kann in einem weiteren Ausführungsbeispiel ein zweiter Kalibrierspiegel zur Kalibrierung des diffraktiven optischen Elements 24 vorgesehen sein.

Entsprechend zur Messanordnung nach Fig. 2 kann die Messordnung 10 gemäß Fig. 6 in einer Vakuumkammer 50 angeordnet sein. Die Eingangswelle 18 des Interferometers 82 wird durch ein geeignet ausgebildetes Fenster 88 ins Innere der Vakuumkammer 50 geführt. Auch enthält die Messanordnung 10 Hitzeschilde 52 zum Schutz des diffraktiven optischen Elements 24 vor Wärmestrahlung von Wärmequellen, wie beispielsweise vor Wärmestrahlung, die von Positionierungsantrieben 54 abgegeben wird. Wie bei der Messanordnung nach Fig. 2 enthält das Substrat des diffraktiven optischen Elements 24 und das Substrat des Kalibrierspiegels 70 vorzugsweise ein Material mit sehr kleinem Wärmeausdehnungskoeffizienten oder ein athermales optisches Material. Zur weiteren Beschreibung dieser Merkmale wird auf die Beschreibung der Messanordnung 10 gemäß Fig. 2 verwiesen.

Ein Beispiel eines Herstellungsverfahrens für einen Spiegel mit einer Betriebstemperatur von über 32°C für ein Projektionsobjektiv einer Projektionsbelichtungsanlage für die Mikrolithographie sieht in einem Schritt eine Herstellung eines Spiegels mit einer entsprechend der Produktionsgenauigkeit an eine vorgegebene Sollform, z.B. eine vorgegebene Freiformfläche, angenäherten Oberfläche vor. Anschließend erfolgt eine Erwärmung des Spiegels auf die vorgegebene Temperatur von über 32°C. Alternativ kann die Erwärmung bereits bei oder vor der Herstellung des Spiegels mit angenäherter Oberflächenform erfolgen. In einem weiteren Schritt wird eine Vermessung der Form der Oberfläche des Spiegels mit einer Messgenauigkeit von kleiner als 0,1 nm RMS durchgeführt. Dazu wird eine interferometrische Messanordnung 10 in einer der vorstehend beschriebenen Ausführungsformen mit einen diffraktiven optischen Element 24, einem reflektiven optischen Element 30 und einer Erfassungseinrichtung 36 verwendet, wobei zumindest das diffraktive optische Element 24 eine Temperatur von unter 25°C, insbesondere Raumtemperatur, aufweist. Zusätzlichen können auch das reflektive optische Element und die Erfassungseinheit eine Temperatur von unter 25°C aufweisen. Nach der Vermessung erfolgt auf Grundlage des Messergebnisses ein Nachbearbeiten der Oberfläche an geeigneten Stellen, sodass diese bei einer Temperatur von über 32°C der Sollform hinreichend genau entspricht. Bei weiteren Ausführungsbeispielen kann eine Wiederholung der Schritte des Vermessen und der Nachbearbeitung vorgesehen sein. Auch kann die absolute Messgenauigkeit kleiner als 0,04 nm RMS betragen oder der Spiegel auf eine Temperatur von über 35°C oder über 40°C erwärmt werden.

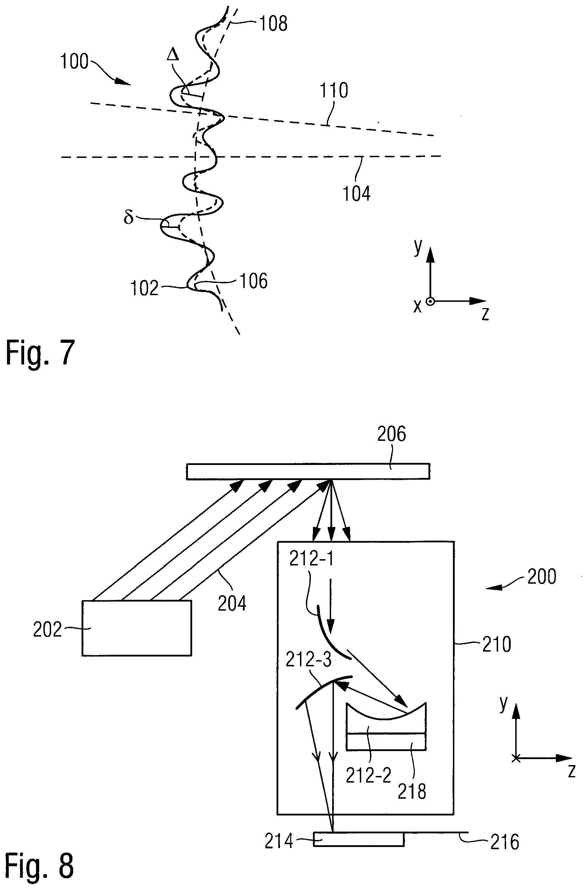

Die beschriebenen Ausführungsbeispiele der Messanordnung 10, des Messverfahrens oder des Herstellungsverfahrens ermöglichen eine Herstellung des erfindungsgemäßen Spiegels, beispielsweise eines hochgenauen EUV-Spiegels mit einer Freiformfläche und einer Betriebstemperatur von größer als 32°C. Die Verfügbarkeit eines derartigen Spiegels ermöglicht wiederum die Herstellung eines erfindungsgemäßen Projektionsobjektivs 210 gemäß Fig. 8.

In Fig. 7 wird ein Ausführungsbeispiel eines Spiegels 100 in einer schematischen Schnittansicht dargestellt. Der Spiegel 100 ist für die Reflexion von EUV-Strahlung mit einer Wellenlänge von < 100 nm, insbesondere einer Wellenlänge von etwa 13,5 nm oder etwa 6,8 nm, bei einer Spiegeltemperatur von über 32°C ausgebildet. Dazu weist der Spiegel 100 eine Oberfläche 102 auf, welche z.B. durch eine entsprechende Beschichtung EUV-Strahlung reflektiert. Alternativ kann als Betriebstemperatur eine Spiegeltemperatur von über 35°C oder über 40°C vorgesehen sein. Fig. 7 zeigt einen Querschnitt des Spiegels 100 senkrecht zu einer Symmetrieebene 104 einer spiegelsymmetrischen Sollform 106. Die Symmetrieebene 104 ist in Fig. 7 parallel zur xz-Ebene und somit senkrecht zur Zeichenebene angeordnet. Die Sollform 106 weist die Gestalt einer spiegelsymmetrischen Freiformfläche auf und ist nicht rotationssymmetrisch.

Weiterhin wird in Fig. 7 eine an die Sollform bestangepasste rotationssymmetrische Asphäre 108 mit einer Rotationsachse 110 dargestellt. Abweichungen der Oberfläche 102 von der Sollform 106 und der Sollform 106 von Asphäre 108 sind zu Veranschaulichungszwecken stark vergrößert dargestellt.

Die maximale Abweichung $\Delta$ der Sollform 104 von der bestangepassten rotationssymmetrischen Asphäre 106 mit der Rotationsachse 110 beträgt bei diesem Ausführungsbeispiel ca. 6 $\mu$m und ist damit größer als 5 $\mu$m. In alternativen Ausführungsbeispielen kann die maximale Abweichung $\Delta$ der Sollform 106 über 10 $\mu$m betragen oder eine Abweichung von jeder Sphäre von mindestens 1 mm aufweisen. Die maximale Abweichung $\delta$ der tatsächlichen Oberfläche 102 von der Sollform 106 beträgt bei der Betriebstemperatur von über 30°C 0,09 nm RMS und ist somit kleiner als 0,1 nm RMS. In weiteren Ausführungsbeispielen ist die maximale Abweichung $\delta$ der Oberfläche 102 auch bei über 35°C oder über 40°C kleiner als 0,1 nm RMS oder kleiner als 0,04 nm RMS.

Fig. 8 zeigt ein Ausführungsbeispiel einer Projektionsbelichtungsanlage 200 für die Mikrolithographie mit einem erfindungsgemäßen Projektionsobjektiv 210 in einer schematischen Veranschaulichung. Das Projektionsobjektiv 210 enthält mindestens einen Spiegel 212-2 gemäß einem der Ausführungsbeispiele nach Fig. 7. Insbesondere ist der Spiegel 212-2 unter Verwendung der erfindungsgemäßen Messvorrichtung 10 bzw. des Herstellungsverfahrens nach einer der vorstehend beschriebenen Ausführungsbeispiele hergestellt worden.

Die Projektionsbelichtungsanlage 200 umfasst ein Beleuchtungssystem 202 zur Erzeugung einer Belichtungsstrahlung 204 in Gestalt von EUV-Strahlung (extrem ultraviolette Strahlung) mit einer Wellenlänge von < 100 nm, insbesondere einer Wellenlänge von etwa 13,5 nm oder etwa 6,8 nm. In anderen, nicht zeichnerisch dargestellten Varianten kann es sich bei der Belichtungsstrahlung 204 um sogenannte DUV-Strahlung, d.h. Strahlung im tiefen UV-Wellenlängenbereich mit einer Wellenlänge von z.B. 248 nm oder 193 nm, handeln.

Die Belichtungsstrahlung 204 trifft auf eine Lithographiemaske 206 mit darauf angeordneten abzubildenden Maskenstrukturen. Dabei kann die Belichtungsstrahlung 204, wie in Fig. 8 gezeigt, an der Lithographie-Maske 206 reflektiert werden, wie dies oft bei Verwendung von EUV-Strahlung der Fall ist. Alternativ kann die Lithographie-Maske 206 auch als Transmissions-Maske ausgeführt sein. In diesem Fall tritt die Belichtungsstrahlung durch die Maske 206 hindurch.

Die Abbildung der Maskenstrukturen auf einen in einer Bildebene 216 angeordneten Wafer 214 erfolgt mittels des Projektionsobjektivs 210, welches eine Vielzahl von Spiegeln umfasst, von denen in Fig. 8 exemplarisch drei Spiegel, nämlich die Spiegel 212-1, 212-2 und 212-3 dargestellt sind. Mindestens einer der Spiegel, im dargestellten Beispiel der Spiegel 212-2, weist Spezifikationen nach einer der oben beschriebenen Ausführungsbeispiele gemäß Fig. 7 auf. Zur Beheizung des Spiegels 212-2 auf eine vorgegebene Betriebstemperatur von über 32°C ist eine Spiegelbeheizungseinrichtung 218 vorgesehen. Die Spiegelbeheizungsvorrichtung 218 ist derart ausgebildet, dass der Spiegel 212-2 unter Berücksichtigung der durch die Belichtungsstrahlung 204 eingebrachten Wärme stets die vorgegeben Betriebstemperatur aufweist. Dazu können in Fig. 8 nicht dargestellte Temperatursensoren und eine Temperaturregelung vorgesehen sein. Weiterhin weist das Projektionsobjektiv bei einer Betriebstemperatur von über 32°C des mindestens einen Spiegels 212-2 eine Systemwellenfront von kleiner als 0,5 nm RMS auf.

In alternativen Ausführungsbeispielen beträgt die vorgegebene Temperatur des Spiegels 212-2 über 35°C oder über 40°C. Zusätzlich kann für einen der Spiegel 212-1 oder 212-3 oder insbesondere für alle Spiegel des Projektionsobjektivs 210 eine Betriebstemperatur von über 32°C, über 35°C oder über 40°C vorgegeben und dafür entsprechende Spiegelbeheizungseinrichtungen vorgesehen sein. Auch in diesen Ausführungen weist das Projektionsobjektiv 210 eine Systemwellenfront von kleiner als 0,5 nm RMS auf. Bei weiteren Ausführungsbeispielen weist das Projektionsobjektiv 210 eine Systemwellenfront von kleiner als 0,2 nm RMS auf.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, sowie Äquivalente vom Schutz der Ansprüche abgedeckt sein.

### Bezugszeichenliste

| | | | |
|---|---|---|---|
| 10 | Messanordnung | 68 | sphärische Kalibrierwelle |
| 12 | optische Oberfläche | 70 | planer Kalibrierspiegel |
| 14 | Testobjekt | 72 | sphärischer Kalibrierspiegel |
| 16 | Lichtquelle | 74 | Verschlussvorrichtung |
| 18 | Eingangswelle | 76 | Shutter |
| 20 | Lichtwellenleiter | 80 | Pfeil Dreh-Schiebe-Verfahren |
| 22 | Austrittsfläche | 82 | Interferometer |
| 24 | diffraktives optisches Element | 83 | Einstrahl-/Detektionsmodul |

(fortgesetzt)

| | | | |
|---|---|---|---|
| 26 | Prüfwelle | 84 | Fizeau-Element |
| 28 | Referenzwelle | 86 | Messwelle |
| 30 | reflektives optisches Element | 88 | Fenster |
| 34 | diffraktive Strukturen | 100 | Spiegel |
| 36 | Erfassungseinrichtung | 102 | Oberfläche |
| 38 | Strahlteiler | 104 | Symmetrieebene Sollform |
| 40 | Interferometerkamera | 106 | Sollform |
| 42 | Ausbreitungsachse | 108 | bestangepasste Asphäre |
| 44 | konvergenter Strahl | 110 | Rotationsachse Asphäre |
| 46 | Okular | 200 | Projektionsbelichtungsanlage |
| 48 | Erfassungsebene | 202 | Beleuchtungssystem |
| 50 | Vakuumkammer | 204 | Belichtungsstrahlung |
| 52 | Hitzeschild | 206 | Lithographiemaske |
| 54 | Positionierungsantrieb | 210 | Projektionsobjektiv |
| 56 | Heizvorrichtung | 212 | Spiegel |
| 58 | Ausbreitungsrichtung Referenzwelle | 214 | Wafer |
| | | 216 | Bildebene |
| 60 | Pfeil Kippuung | 218 | Spiegelbeheizungseinrichtung |
| 62 | gekippte Referenzwelle | | |
| 64 | Pfeil Verschiebung | | |
| 66 | ebene Kalibrierwelle | | |

## Patentansprüche

1. Messanordnung zur interferometrischen Bestimmung einer Form einer Oberfläche eines Testobjekts in Gestalt eines optischen Elements der Mikrolithographie, umfassend:

   - eine Lichtquelle zum Bereitstellen einer Eingangswelle,
   - ein diffraktives optisches Element, welches im Strahlengang der Eingangswelle angeordnet und geeignet konfiguriert ist, jeweils durch Beugung in betragsmäßig erster oder höherer Ordnung aus der Eingangswelle einerseits eine auf das Testobjekt gerichtete Prüfwelle mit einer zumindest teilweise an eine Sollform der optischen Oberfläche angepassten Wellenfront und andererseits eine Referenzwelle mit einer von einer Ausbreitungsrichtung der Prüfwelle abweichenden Ausbreitungsrichtung zu erzeugen, wobei das diffraktive optische Element in einer Ebene zwei sich überlagernd angeordnete diffraktive Strukturmuster aufweist und wobei eines der diffraktiven Strukturmuster zur Erzeugung der Prüfwelle und das andere diffraktive Strukturmuster zur Erzeugung der Referenzwelle ausgebildet ist,
   - ein reflektives optisches Element, welches im Strahlengang der Referenzwelle angeordnet ist und zur Rückreflexion der Referenzwelle ausgebildet ist,
   - eine Erfassungseinrichtung zum Erfassen eines Interferogramms, welches durch eine Überlagerung der Prüfwelle nach Wechselwirkung mit dem Testobjekt und der rückreflektierten Referenzwelle, jeweils nach erneuter Beugung am diffraktiven optischen Element in einer Erfassungsebene, erzeugt wird.

2. Messanordnung nach Anspruch 1,
   welche dazu konfiguriert ist, dass bei der erneuten Beugung die Prüfwelle mit der gleichen Beugungsordnung am diffraktiven optischen Element gebeugt wird wie die Eingangswelle bei der zur Erzeugung der Prüfwelle erfolgten Beugung am diffraktiven optischen Element.

3. Messanordnung nach Anspruch 1 oder 2,
   welche derart konfiguriert ist, dass bei der erneuten Beugung die Referenzwelle mit der gleichen Beugungsordnung am diffraktiven optischen Element gebeugt wird wie die Eingangswelle bei der zur Erzeugung der Referenzwelle erfolgten Beugung am diffraktiven optischen Element.

4. Messanordnung nach einem der vorausgehenden Ansprüche,

welche dazu konfiguriert ist, dass die Ausbreitungsrichtung der durch Beugung am diffraktiven optischen Element aus der Eingangswelle erzeugten Referenzwelle gegenüber der Ausbreitungsrichtung der Eingangswelle um mehr als 1° verkippt ist.

5. Messanordnung nach einem der vorausgehenden Ansprüche, wobei bei der erneuten Beugung am diffraktiven optischen Element eine durch Überlagerung der Prüfwelle nach Wechselwirkung mit dem Testobjekt und der rückreflektierten Referenzwelle gebildete Rücklaufwelle erzeugt wird und wobei die Messanordnung dazu konfiguriert ist, dass die Ausbreitungsrichtung der Rücklaufwelle gegenüber der umgekehrten Ausbreitungsrichtung der Eingangswelle um weniger als 1° verkippt ist.

6. Messanordnung nach einem der vorausgehenden Ansprüche, welche dazu konfiguriert ist, dass die Wellenfront der Prüfwelle nach der erneuten Beugung am diffraktiven optischen Element um maximal 10 $\mu$m von einer an die Wellenfront der Eingangswelle bestangepassten sphärischen Wellenfront abweicht.

7. Messanordnung nach einem der vorausgehenden Ansprüche, wobei das diffraktive Strukturmuster zur Erzeugung der Referenzwelle weiterhin zum derartigen Anpassen der Wellenfront der Referenzwelle an die Form des reflektiven optischen Elements ausgebildet ist, dass die Referenzwelle zum diffraktiven Element zurückreflektiert wird.

8. Messanordnung nach einem der vorangegangenen Ansprüche, wobei das reflektive optische Element gegenüber einer zur Ausbreitungsrichtung der Referenzwelle senkrecht angeordneten Achse kippbar gelagert ist.

9. Messanordnung nach einem der vorangegangenen Ansprüche, wobei das reflektive optische Element entlang einer Ausbreitungsrichtung der Referenzwelle verschiebbar gelagert ist.

10. Verfahren zum interferometrischen Bestimmen einer Form einer Oberfläche (12) eines Testobjekts (14) in Gestalt eines optischen Elements der Mikrolithographie, umfassend die folgenden Schritte:

    - Bereitstellen einer Eingangswelle (18),
    - Erzeugen einer auf das Testobjekt (14) gerichteten Prüfwelle (26) mit einer zumindest teilweise an eine Sollform der optischen Oberfläche (12) angepassten Wellenfront und einer auf ein reflektives optisches Element (30) gerichteten Referenzwelle (28) mit einer von einer Ausbreitungsrichtung der Prüfwelle (26) abweichenden Ausbreitungsrichtung aus der Eingangswelle (18) jeweils durch Beugung in betragsmäßig erster oder höherer Ordnung an einem diffraktiven optischen Element (24), wobei das diffraktive optische Element in einer Ebene zwei sich überlagernd angeordnete diffraktive Strukturmuster aufweist und wobei die Prüfwelle an einem der diffraktiven Strukturmuster und die Referenzwelle an dem anderen diffraktiven Strukturmuster erzeugt wird,
    - Überlagern der Prüfwelle (26) nach Wechselwirkung mit dem Testobjekt (14) mit der Referenzwelle (28) nach Rückreflexion am reflektiven optischen Element (30), wobei die Prüfwelle (26) und die Referenzwelle (28) zur Überlagerung jeweils am diffraktiven optischen Element (24) erneut gebeugt werden, und
    - Erfassen eines durch die Überlagerung der Prüfwelle (26) und der Referenzwelle (28) in einer Erfassungsebene (48) erzeugten Interferogramms.

11. Verfahren nach Anspruch 10, weiterhin umfassend die Schritte:

    - Erzeugen mindestens einer auf einen Kalibrierspiegel gerichteten Kalibrierwelle mit ebener oder sphärischer Wellenfront aus der Eingangswelle durch das diffraktive optische Element,
    - Bestimmen von Oberflächenfehlern des reflektiven optischen Elements und des mindestens einen Kalibrierspiegels,
    - Messen einer Wellenfrontdifferenz zwischen dem reflektiven optischen Element und dem Kalibrierspiegel,
    - Bestimmen von Kalibrierkorrekturen aus der gemessenen Wellenfrontdifferenz und den Oberflächenfehlern,
    - Bestimmen der Form der Oberfläche des Testobjekts aus dem erfassten Interferogramm unter Berücksichtigung der Kalibrierkorrekturen.

**Claims**

1.  A measurement arrangement for interferometrically determining a shape of a surface of a test object in form of an optical element of microlithography, comprising:

    - a light source for providing an input wave,
    - a diffractive optical element which is arranged in the beam path of the input wave and is suitably configured to produce in each case by way of, in terms of absolute value, first-order or higher-order diffraction from the input wave a test wave, which is directed at the test object and has a wavefront that is adapted at least partially to a desired shape of the optical surface, and a reference wave having a propagation direction that deviates from a propagation direction of the test wave, wherein the diffractive optical element has two diffractive structural patterns that are arranged such that they superimpose each other in a plane, and wherein one of the diffractive structural patterns is configured for producing the test wave and the other diffractive structural pattern is configured for producing the reference wave,
    - a reflective optical element which is arranged in the beam path of the reference wave and is configured for back-reflection of the reference wave,
    - a capture device for capturing an interferogram which is produced by superposition of the test wave after interaction with the test object and the back-reflected reference wave, in each case after a further diffraction at the diffractive optical element in a capture plane.

2.  The measurement arrangement as claimed in claim 1,
    which is configured such that, upon the further diffraction, the test wave is diffracted at the diffractive optical element with the same order of diffraction as the input wave upon the diffraction at the diffractive optical element that takes place to produce the test wave.

3.  The measurement arrangement as claimed in claim 1 or 2,
    which is configured such that, upon the further diffraction, the reference wave is diffracted at the diffractive optical element with the same order of diffraction as the input wave upon the diffraction at the diffractive optical element that takes place to produce the input wave.

4.  The measurement arrangement as claimed in any one of the preceding claims,
    which is configured such that the propagation direction of the reference wave, which is produced by diffraction at the diffractive optical element from the input wave, is tilted with respect to the propagation direction of the input wave by more than 1°.

5.  The measurement arrangement as claimed in any one of the preceding claims,
    wherein, upon the further diffraction at the diffractive optical element, a return wave is produced by superposition of the test wave after interaction with the test object and the back-reflected reference wave, and wherein the measurement arrangement is configured such that the propagation direction of the return wave is tilted with respect to the reverse propagation direction of the input wave by less than 1°.

6.  The measurement arrangement as claimed in any one of the preceding claims,
    which is configured such that the wavefront of the test wave after the further diffraction at the diffractive optical element deviates from a spherical wavefront that is best adapted to the wavefront of the input wave by at most 10 $\mu$m.

7.  The measurement arrangement as claimed in any one of the preceding claims,
    wherein the diffractive structural pattern for producing the reference wave is furthermore configured for adapting the wavefront of the reference wave to the shape of the reflective optical element such that the reference wave is reflected back to the diffractive element.

8.  The measurement arrangement as claimed in any one of the preceding claims,
    wherein the reflective optical element is mounted such that it is tiltable with respect to an axis that is arranged perpendicular to the propagation direction of the reference wave.

9.  The measurement arrangement as claimed in any one of the preceding claims,
    wherein the reflective optical element is mounted such that it is displaceable along a propagation direction of the reference wave.

10. A method for interferometrically determining a shape of a surface (12) of a test object (14) in form of an optical element of microlithography, comprising the following steps:

- providing an input wave (18),
- producing a test wave (26), which is directed at the test object (14) and has a wavefront that is adapted at least partially to a desired shape of the optical surface (12), and a reference wave (28), which is directed at a reflective optical element (30) and has a propagation direction that deviates from a propagation direction of the test wave (26), from the input wave (18) in each case by, in terms of absolute value, first order or higher order diffraction at a diffractive optical element (24), wherein the diffractive optical element has two diffractive structural patterns that are arranged such that they superimpose each other in a plane, and wherein the test wave is produced at one of the diffractive structural patterns and the reference wave is produced at the the other diffractive structural pattern,
- superposing the test wave (26) after interaction with the test object (14) with the reference wave (28) after back-reflection at the reflective optical element (30), wherein the test wave (26) and the reference wave (28) are diffracted again in each case at the diffractive optical element (24) for superposition,
- capturing an interferogram produced by the superposition of the test wave (26) and the reference wave (28) in a capture plane (48).

11. The method as claimed in claim 10, comprising the steps of:

- producing at least one calibration wave which is directed at a calibration mirror and has a plane or spherical wavefront from the input wave by way of the diffractive optical element,
- determining surface defects of the reflective optical element and the at least one calibration mirror,
- measuring a wavefront difference between the reflective optical element and the calibration mirror,
- determining calibration corrections from the measured wavefront difference and the surface defects,
- determining the shape of the surface of the test object from the captured interferogram taking into consideration the calibration corrections.


**Revendications**

1. Arrangement de mesure destiné à la détermination par interférométrie d'une forme d'une surface d'un objet en essai sous la forme d'un élément optique de la microlithographie, comprenant :

- une source de lumière destinée à fournir une onde d'entrée,
- un élément optique diffractif, qui est disposé dans le trajet de rayon de l'onde d'entrée et est configuré de manière appropriée, respectivement par diffraction dans le premier ordre ou un ordre supérieur en terme de montant, pour générer à partir de l'onde d'entrée d'une part une onde de contrôle orientée sur l'objet en essai avec un front d'onde au moins partiellement adapté à une forme voulue de la surface optique et d'autre part une onde de référence ayant une direction de propagation différente d'une direction de propagation de l'onde de contrôle, l'élément optique diffractif possédant dans un plan deux modèles de structure diffractive disposés en se superposant et l'un des modèles de structure diffractive étant configuré pour générer l'onde de contrôle et l'autre modèle de structure diffractive pour générer l'onde de référence,
- un élément optique réfléchissant, qui est disposé dans le trajet de rayon de l'onde de référence et est configuré pour la rétroréflexion de l'onde de référence,
- un dispositif de détection destiné à détecter un interférogramme, lequel est généré par une superposition de l'onde de contrôle, après une interaction avec l'objet en essai, et de l'onde de référence rétroréfléchie, respectivement après une nouvelle diffraction au niveau de l'élément optique diffractif dans un plan de détection.

2. Arrangement de mesure selon la revendication 1, lequel est configuré pour que lors de la nouvelle diffraction, l'onde de contrôle soit diffractée au niveau de l'élément optique diffractif avec le même ordre de diffraction que l'onde d'entrée lors de la diffraction effectuée au niveau de l'élément optique diffractif pour générer l'onde de contrôle.

3. Arrangement de mesure selon la revendication 1 ou 2, lequel est configuré pour que lors de la nouvelle diffraction, l'onde de référence soit diffractée au niveau de l'élément optique diffractif avec le même ordre de diffraction que l'onde d'entrée lors de la diffraction effectuée au niveau de l'élément optique diffractif pour générer l'onde de référence.

**4.** Arrangement de mesure selon l'une des revendications précédentes, lequel est configuré pour que la direction de propagation de l'onde de référence, générée à partir de l'onde d'entrée par diffraction au niveau de l'élément optique diffractif, soit désalignée de plus de 1° par rapport à la direction de propagation de l'onde d'entrée.

**5.** Arrangement de mesure selon l'une des revendications précédentes, avec lequel, lors de la nouvelle diffraction au niveau de l'élément optique diffractif, une onde de retour formée par la superposition de l'onde de contrôle après l'interaction avec l'objet en essai et de l'onde de référence rétroréfléchie est générée et l'arrangement de mesure étant configuré pour que la direction de propagation de l'onde de retour soit désalignée de moins de 1° par rapport à la direction de propagation inverse de l'onde d'entrée.

**6.** Arrangement de mesure selon l'une des revendications précédentes, lequel est configuré pour que le front d'onde de l'onde de contrôle, après la nouvelle diffraction au niveau de l'élément optique diffractif, s'écarte au maximum de 10 $\mu$m d'un front d'onde sphérique le mieux adapté au front d'onde de l'onde d'entrée.

**7.** Arrangement de mesure selon l'une des revendications précédentes, le modèle de structure diffractive destiné à générer l'onde de référence étant en outre configuré pour adapter le front d'onde de l'onde de référence à la forme de l'élément optique réfléchissant de telle sorte que l'onde de référence est rétroréfléchie vers l'élément diffractif.

**8.** Arrangement de mesure selon l'une des revendications précédentes, l'élément optique réfléchissant étant monté inclinable par rapport à un axe disposé perpendiculairement à la direction de propagation de l'onde de référence.

**9.** Arrangement de mesure selon l'une des revendications précédentes, l'élément optique réfléchissant étant monté coulissant le long d'une direction de propagation de l'onde de référence.

**10.** Procédé de détermination par interférométrie d'une forme d'une surface (12) d'un objet en essai (14) sous la forme d'un élément optique de la microlithographie, comprenant les étapes suivantes :

- fourniture d'une onde d'entrée (18),
- génération, à partir de l'onde d'entrée (18), d'une onde de contrôle (26) orientée sur l'objet en essai (14) avec un front d'onde au moins partiellement adapté à une forme voulue de la surface optique (12) et d'une onde de référence (28) orientée sur un élément optique réfléchissant (30) ayant une direction de propagation différente d'une direction de propagation de l'onde de contrôle (26), respectivement par diffraction dans le premier ordre ou un ordre supérieur en terme de montant au niveau d'un élément optique diffractif (24), l'élément optique diffractif possédant dans un plan deux modèles de structure diffractive disposés en se superposant et l'onde de contrôle étant générée au niveau de l'un des modèles de structure diffractive et l'onde de référence au niveau de l'autre modèle de structure diffractive,
- superposition de l'onde de contrôle (26) après une interaction avec l'objet en essai (14) avec l'onde de référence (28) après la rétroréflexion au niveau de l'élément optique réfléchissant (30), l'onde de contrôle (26) et l'onde de référence (28) étant de nouveau respectivement diffractées au niveau de l'élément optique diffractif (24) en vue de la superposition, et
- détection d'un interférogramme généré par la superposition de l'onde de contrôle (26) et de l'onde de référence (28) dans un plan de détection (48).

**11.** Procédé selon la revendication 10, comprenant en outre les étapes suivantes :

- génération, par l'élément optique diffractif à partir de l'onde d'entrée, d'au moins une onde d'étalonnage, orientée sur un miroir d'étalonnage, ayant un front d'onde plan ou sphérique,
- détermination de défauts de surface de l'élément optique réfléchissant et de l'au moins un miroir d'étalonnage,
- mesure d'une différence de front d'onde entre l'élément optique réfléchissant et le miroir d'étalonnage,
- détermination de corrections d'étalonnage à partir de la différence de front d'onde mesurée et des défauts de surface,
- détermination de la forme de la surface de l'objet en essai à partir de l'interférogramme détecté en tenant compte des corrections d'étalonnage.

Fig. 1

Fig. 2

Fig. 3a

Fig. 3b

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012217800 A1
- US 5361312 A
- DE 19820785 A1

**In der Beschreibung aufgeführte Nicht-Patentliteratur**

- **SU et al.** Absolute surface figure testing by shift-rotation method using Zernike polynomials. *Optics Letters,* 2012, vol. 37 (15), 3198-3200
- **R. SCHREINER et al.** Absolute testing of the reference surface of a Fizeau interferometer through even/odd decompositions. *Applied Optics,* 10. November 2008, vol. 47 (32